# EUROPÄISCHE PATENTSCHRIFT

(11) **EP 2 339 646 B1**
(45) Veröffentlichungstag und Bekanntmachung des Hinweises auf die Patenterteilung: **06.09.2017**
(21) Anmeldenummer: 10015971.4
(22) Anmeldetag: 22.12.2010
(51) Int. Cl.: H02S 40/34, H01L 31/02

(54) **Solarmodul, Anschlussdose, Solarmodulverbinderanordnung, Verfahren und Verwendung**
Solar module, connection socket, solar module connection assembly, method and application
Module solaire, boîtier de raccordement, agencement de connecteurs de module solaire, procédé et utilisation

(30) Priorität: 23.12.2009 DE 102009060306
(43) Veröffentlichungstag der Anmeldung: 29.06.2011
(73) Patentinhaber: Yamaichi Electronics Deutschland GmbH, 85609 Aschheim-Dornach (DE)
(72) Erfinder: Quiter, Michael, 57482 Wenden (DE)
(74) Vertreter: Müller-Boré & Partner Patentanwälte PartG mbB

(56) Entgegenhaltungen:
- EP-A1- 0 999 601
- EP-A1- 1 006 593
- DE-A1- 10 052 529
- DE-A1-102007 031 351
- DE-B3- 10 334 935

## Beschreibung

Die Erfindung betrifft ein Solarmodul, einen Solarmodulverbinder, eine Anschlußdose, eine Verwendung des Solarmoduls und der Anschlußdose sowie ein Verfahren zum Herstellen eines Solarmoduls.

Herkömmliche Solarmodule zur Erzeugung elektrischer Energie aus Sonnenlicht umfassen eine oder mehrere einzelne Solarzellen. Je nach gewünschter vom Solarmodul zur Verfügung zu stellenden Spannung und/oder Stromstärke werden einzelne Solarzellen innerhalb des Moduls parallel und/oder in Reihe geschaltet und damit zu Solarzellengruppen zusammengefaßt. Die Solarzellengruppen werden zu einem flachen Solarmodul zusammengefaßt. Die elektrischen Anschlüsse der Solarzellengruppen des Solarmoduls werden in der Regel auf eine Anschlußseite des Solarmoduls nach außen geführt, wobei die Anschlußseite bei bestimmungsgemäßem Gebrauch des Solarmoduls von einer Lichtquelle bestrahlten Bestrahlungsseite abgewandt angeordnet ist.

An dem Solarmodul ist daher in der Regel eine elektrische Anschlußdose befestigt, welche mittels einer Kontaktvorrichtung dünne flexible Leiterbänder, welche mit den einzelnen Solarzellengruppen elektrisch verbunden sind, elektrisch kontaktiert. Um die Leiterbänder anschließen zu können, werden diese üblicherweise von unten in die Anschlußdose eingeführt, die einen abnehmbaren Gehäusedeckel aufweist, und von Hand mit einer in der Anschlußdose vorhandenen Kontaktvorrichtung kontaktiert. Desweiteren kann die Anschlußdose weitere elektrische bzw. elektronische Bauteile aufweisen, beispielsweise Bypass-Dioden.

Eine derartige manuelle Montage ist sehr zeitintensiv, wodurch sich ein Bedarf nach einem automatisierten Anschließen eines Solarmoduls ergibt. Aufgrund der hohen Flexiblität und mechanischen Empfindlichkeit der aus dem Solarmodul herausgeführten dünnen Leiterbänder ist das automatisierte Anschließen jedoch erschwert. Insbesondere ist die Position der dünnen Leiterbänder aufgrund der hohen Flexibilität der Leiterbänder von Solarmodul zu Solarmodul verschieden.

DE 100 52 529 A1 betrifft ein Solarmodul mit zwei parallel und mit Abstand zueinander angeordneten Glasscheiben, zwischen denen innerhalb einer Folie mindestens eine Soalrzelle eingebettet ist, die durch an einer Durchgangsbohrung aus dem Solarmodul herausgeführte Leitungen elektrisch angeschlossen ist. Damit die elektrischen Leitungen lagesicher und vor Beschädigungen geschützt anordbar und das Solarmodul ortsfest montierbar ist, ist eine formstabile Anschlussdose in oder an der Durchgangsbohrung befestigt. Die Anschlussdose weist Kammern auf, in die die Leitungen und elektrische Bauelemente einsetzbar sind, wobei in der Anschlussdose eine Durchführung ausgebildet ist, durch die ein Befestigungselement für das Solarmodul führbar ist.

Die Druckschrift DE 10 2007 031 351 A1 offenbart eine Verbindungsvorrichtung zur Verbindung mindestens eines ersten elektrischen Leiters mit mindestens einem elektrischen Leiter eines photovoltaischen Solarmoduls. Die Verbindungsvorrichtung umfasst ein Verbindergehäuse zur Anordnung auf einer Außenfläche des Solarmoduls und eine in dem Verbindergehäuse angeordnete Zwischenverbindungsanordnung mit einem ersten Kontaktbereich zur Verbindung mit dem ersten elektrischen Leiter und einem zweiten Kontaktbereich zur Verbindung mit dem elektrischen Leiter des photovoltaischen Solarmoduls. Der zweite Kontaktbereich ist an ein Kontaktelement anschließbar, das mit dem elektrischen Leiter des Solarmoduls verbunden ist. Wenigstens der zweite Kontaktbereich der Zwischenverbindungsanordnung ist derart ausgestaltet, dass der Anschluss an das Kontaktelement über eine Steckverbindung herstellbar ist.

Die Druckschrift DE 103 34 935 B3 offenbart eine Anschlusseinrichtung für ein Solarstrommodul zur Weiterleitung des mittels photovoltaischer Solarelemente gewonnenen Stromes. Die Anschlusseinrichtung ist in einem Anschlussgehäuse untergebracht und ist mit den Solarelementen verbindbar. Die Solarelemente sind durch flache Verbindungsleiter miteinander verbunden und in einem transluziden Scheibenverbund eingebettet. Über eine Öffnung in einer der Scheiben des Scheibenverbundes wird der Strom über federnde Kontaktelemente entnommen, die in elektrischem Kontakt zu den Verbindungsleitern der Solarelemente stehen.

Es ist daher eine Aufgabe der vorliegenden Erfindung ein Solarmodul, eine Solarmodulanordnung mit einer Anschlußdose und ein Verfahren zum Herstellen des Solarmoduls bereitzustellen, das eine vereinfachte automatisierte Kontaktierung ermöglicht. Die Aufgabe wird durch die unabhängigen Ansprüche gelöst. Bevorzugte Ausführungsformen sind Gegenstand der abhängigen Ansprüche.

### Solarmodul gemäß einem Aspekt

Ein Aspekt der vorliegenden Erfindung betrifft ein Solarmodul, umfassend:
- einen anschlußseitigen Solarmodulkörper mit zumindest einer Solarmodulverbinderöffnung,
- zumindest einen Solarmodulverbinder mit
   -- zumindest einem Einführbereich, in welchen zumindest ein Kontaktelement eines komplementären Solarmodulverbinders entlang einer Einführrichtung E einführbar ist,
   -- zumindest einem elektrischen Leiter, welcher mit zumindest einer Solarzelle kontaktiert ist,
   -- zumindest einer Leiterhalteeinrichtung, welche einen zugeordneten des zumindest einen elektrischen Leiters mechanisch fixiert, wobei sich der zugeordnete elektrische Leiter in einem Leiterkontaktabschnitt im wesentlichen parallel zur Einführrichtung E erstreckt,
wobei der Solarmodulverbinder zumindest bereichsweise im Bereich der Solarmodulverbinderöffnung in den anschlußseitigen Solarmodulkörper hineinragt.

Vorteilhafterweise kann das Solarmodul in einfacher Weise durch Einführen des zumindest einen Kontaktelements des komplementären Solarmodulverbinders elektrisch kontaktiert werden, um die von dem Solarmodul bereitgestellte elektrische Energie einem externen Verbraucher zuführen zu können. Weiter vorteilhafterweise ist es nicht mehr notwendig, die gegenüber mechanischen Beanspruchungen empfindlichen elektrischen Leiter aus dem Solarmodul herauszuführen, um diese mit einer außen an dem Solarmodul befestigten Anschlußdose manuell zu verbinden. Mittels der Leiterhalteeinrichtung des Solarmodulverbinders werden die mit der Solarzelle des Solarmoduls verbundenen elektrischen Leiter sicher positioniert und vorteilhafterweise vor mechanischer Beanspruchung, beispielsweise durch Biege- oder Zugbelastung, geschützt.

Der anschlußseitige Solarmodulkörper des Solarmoduls kann ein transparentes oder ein intransparentes Material umfassen, wobei der anschlußseitige Solarmodulkörper bevorzugt eben bzw. plattenförmig ausgebildet ist. Insbesondere kann der anschlußseitige Solarmodulkörper eine Glasplatte oder eine Polymerplatte aufweisen. Der anschlußseitige Solarmodulkörper ist auf der der Bestrahlungsseite, d.h. der bei betriebsgemäßem Gebrauch vom Licht bestrahlten Seite, gegenüberliegenden bzw. entgegengesetzten Seite des Solarmoduls angeordnet. Weiter umfaßt das Solarmodul zumindest eine spannungserzeugende Solarzelle, welche zwischen einem bestrahlungsseitigen Solarmodulkörper und dem anschlußseitigen Solarmodulkörper angeordnet sein kann.

Der anschlußseitige Solarmodulkörper umfaßt eine Solarmodulverbinderöffnung, welche ausgelegt ist, einen Solarmodulverbinder zumindest bereichsweise aufzunehmen. Mit anderen Worten ragt der Solarmodulverbinder zumindest bereichsweise in die Solarmodulverbinderöffnung des anschlußseitigen Solarmodulkörpers hinein. Es versteht sich, daß der Solarmodulverbinder auch vollständig in der Solarmodulverbinderöffnung aufgenommen sein kann. Die Solarmodulverbinderöffnung ermöglicht einen Zugang zu dem Solarmodulverbinder, wobei die Solarmodulverbinderöffnung beispielsweise als rechteckige oder kreisförmige Öffnung in dem anschlußseitigen Solarmodulkörper ausgebildet sein kann. Bevorzugt ist die Solarmodulverbinderöffnung als durchgehende Bohrung in dem anschlußseitigen Solarmodulkörper ausgebildet. Der Solarmodulverbinder weist zumindest einen elektrischen Leiter auf, welcher vorzugsweise die Form eines

Leiterbandes bzw. eines ebenen elektrischen Leiters aufweist. Der zumindest eine elektrische Leiter des Solarmodulverbinders ist mit einer der zumindest einen Solarzelle elektrisch kontaktiert, um die von der Solarzelle erzeugte elektrische Leistung abzugreifen.

Der zumindest eine Solarmodulverbinder umfaßt zumindest einen Einführbereich. Es versteht sich, daß das Solarmodul auch eine Mehrzahl von 2, 3, 4, usw. Solarmodulverbindern aufweisen kann sowie daß ein Solarmodulverbinder eine Mehrzahl von 2, 3, 4, usw. Einführbereichen aufweisen kann. Der Einführbereich ist bzw. die Einführbereiche sind derart ausgebildet, daß zumindest ein Kontaktelement eines komplementären Solarmodulverbinders entlang einer Einführrichtung E zumindest bereichsweise in jeden Einführbereich einführbar ist. Bevorzugt sind eine Mehrzahl von beispielsweise 2, 3, 4,5, 6, 7, 8 usw. Kontaktelemente in jeden Einführbereich einführbar. Weiter bevorzugt ist der komplementäre Solarmodulverbinder entlang der Einführrichtung E zumindest bereichsweise in den Einführbereich einführbar. Es versteht sich, daß durch das zumindest bereichsweise Einführen des zumindest einen Kontaktelements bzw. des komplementären Solarmodulverbinders in den Einführbereich ein elektrischer Kontakt zwischen jedem Kontaktelement des komplementären Solarmodulverbinders und einem zugeordneten elektrischen Leiter des Solarmodulverbinders ausbildbar ist.

Der Abschnitt eines jeden des zumindest einen elektrischen Leiters, der ausgelegt ist, mit einem zugeordneten Kontaktelement des komplementären Solarmodulverbinders elektrisch zu kontaktieren, wird als Leiterkontaktabschnitt bezeichnet. Der Leiterkontaktabschnitt eines jeden des zumindest einen elektrischen Leiters erstreckt sich im wesentlichen parallel zur Einführrichtung E. Der Begriff "im wesentlichen parallel" bedeutet in diesem Zusammenhang, daß die Erstreckungsrichtung jedes Leiterkontaktabschnitts zusammen mit der Einführrichtung E einen Winkel von kleiner als 15 Grad, bevorzugt kleiner als 10 Grad, insbesondere kleiner als 5 Grad einschließt. Der Begriff "im wesentlichen parallel" schließt auch eine identische Parallelität, d.h. genau parallel, ein. Aufgrund der Parallelität von Einführrichtung E und der Erstreckungsrichtung eines jeden der Leiterkontaktabschnitte wird die durch das Einführen des zumindest einen Kontaktelements bzw. des komplementären Solarmodulsverbinders entlang der Einführrichtung E erzeugte mechanische Spannung in dem Solarmodul verringert, da das Kontaktelemente beim Einführen im wesentlichen reibungsarm über den zugeordneten Leiterkontaktabschnitt des zumindest einen elektrischen Leiters gleiten kann. Der zumindest eine elektrische Leiter bzw. der Leiterkontaktabschnitt ist mittels zumindest einer zugeordneten Leiterhalteeinrichtung mechanisch fixiert. Insbesondere verhindert eine der zumindest einen Leiterhalteeinrichtung die räumlichen Verlagerung bzw. die Verformung des dieser Leiterhalteeinrichtung zugeordneten elektrischen Leiters. Insbesondere wird eine räumlichen Verlagerung entlang der Einführrichtung E und/oder eine Verlagerung senkrecht zu der Einführrichtung E verhindert.

### Ausführungsformen des Solarmoduls

Vorzugsweise ist die zumindest eine Leiterhalteeinrichtung als Widerlager des zugeordneten elektrischen Leiters gegenüber einer Andruckkraft K ausgebildet, welche in einer zu der Einführrichtung E verschiedenen Richtung auf den zugeordneten elektrischen Leiter wirkt. Beispielsweise können die Einführrichtung E und die Andruckkraft K einen Winkel α von 60 Grad bis 90 Grad, weiter bevorzugt einen Winkel α von 75 Grad bis 90 Grad, insbesondere einen Winkel α von 85 Grad bis 90 Grad einschließen.

Vorzugsweise ist die Richtung der Andruckkraft K im wesentlichen senkrecht zu der Einführrichtung E. Weiter bevorzugt kann die Andruckkraft K von einer Mittelachse der Solarmodulverbinderöffnung aus radial nach außen zum Rand der Solarmodulverbinderöffnung hin orientiert sein. Insbesondere können die elektrischen Leiter mittels eines zugeordneten Kontaktelements des komplementären Solarmodulverbinders radial nach außen gegen das Widerlager des elektrischen Leiters gepreßt werden. Weiter bevorzugt wirkt lediglich die Andruckkraft K auf die elektrischen Leiter, insbesondere lediglich radial nach außen. Insbesondere können die Kontaktelemente des komplementären Solarmodulverbinders unmittelbar mit den elektrischen Leitern, beispielsweise den Leiterbändern, des Solarmoduls elektrisch und mechanisch kontaktieren. Insbesondere ist es nicht notwendig die elektrischen Leiter des Solarmoduls mechanisch zu verstärken, beispielsweise mit Kabelschuhen, Kontakten unter so weiter.

Bevorzugt können sich die zumindest eine Leiterhalteeinrichtung und der zugeordnete elektrische Leiter unmittelbar mechanisch kontaktieren. Die Leiterhalteeinrichtung bzw. der durch die Leiterhalteeinrichtung fixierte zugeordnete elektrische Leiter ist bzw. sind ausgelegt, um durch ein zugeordnetes des zumindest einen Kontaktelementes des komplementären Solarmodulverbinders durch das zumindest bereichsweise Einführen des Kontaktelementes in den Einführbereich des Solarmodulverbinders des Solarmoduls mechanisch und elektrisch kontaktiert zu werden. Dabei kann das zugeordnete Kontaktelement eine Andruckkraft K auf den elektrischen Leiter anlegen, der durch die Leiterhalteeinrichtung fixiert bzw. gehalten ist. Bevorzugt ist jeder elektrische Leiter für eine Andruckkraft K von größer als 0,1 N, bevorzugt größer als 1 N und insbesondere größer als 3 N ausgelegt.

Besonders bevorzugt ist jeder der elektrischen Leiter im Bereich der Solarmodulverbinders lediglich einmal gebogen bzw. umgebogen. Beispielsweise kann einer der an der Biegestelle angrenzenden Teile des elektrischen Leiters innerhalb einer Ebene parallel zur Erstreckung des anschlußseitigen Solarmodulkörpers liegen, während der andere Teil des elektrischen Leiters sich auch in einer Richtung parallel zur Einführrichtung E erstreckt. Durch das Vorhandensein lediglich einer Biegung bzw. Biegestelle ist die mechanische Beanspruchung des elektrischen Leiters vorteilhafterweise vermindert.

Erfindungsgemäß ist der zumindest eine elektrische Leiter als Leiterband ausgebildet, wobei die gegenüberliegenden Ränder des Leiterbandes jeweils in einer entlang der Einführrichtung E orientierten Nut der zugeordneten Leiterhalteeinrichtung gehalten sind. Der Begriff "Leiterband" beschreibt einen elektrischen Leiter, welcher im wesentlichen bandförmig, also mit einer Leiterbandbreite, die um einen Faktor von größer als 5, bevorzugt von größer als 10, insbesondere von größer als 50 breiter ist als die Dicke des Leiterbandes. Beispielsweise kann die Leiterbandbreite 7 mm betragen, wobei die Leiterbanddicke 0,3 mm beträgt. Das Leiterband kann aus einem Metall, beispielsweise einer Kupferlegierung, ausgebildet sein.

Vorzugsweise ist der zumindest eine Solarmodulverbinder zumindest bereichsweise zwischen dem bestrahlungsseitigen Solarmodulkörper und dem anschlußseitigen Solarmodulkörper angeordnet. Vorteilhafterweise kann der Solarmodulverbinder in einfacher Weise räumlich fixiert bzw. befestigt werden, insbesondere gegenüber einer Verlagerung entgegen der Einführrichtung E, wenn der Solarmodulverbinder durch die zumindest bereichsweise Anordnung zwischen dem bestrahlungsseitigen Solarmodulkörper und dem anschlußseitigen Solarmodulkörper des Solarmoduls festgelegt bzw. festgeklemmt ist. Der Solarmodulverbinder kann alternativ oder zusätzlich mittelbar oder unmittelbar mit dem bestrahlungsseitigen Solarmodulkörper oder und dem anschlußseitigen Solarmodulkörper verklebt sein. Bevorzugt kann der Solarmodulverbinder durch Laminieren mit dem bestrahlungsseitigen Solarmodulkörper oder mit einer an dem bestrahlungsseitigen Solarmodulkörper angeordneten elektrisch isolierenden Schicht verbunden sein.

Vorzugsweise steht der Solarmodulverbinder nicht entgegen der Einführrichtung E über den anschlußseitigen Solarmodulkörper hervor. Mit anderen Worten kann der Solarmodulverbinder in der Solarmodulverbinderöffnung aufgenommen sein. Vorteilhafterweise ist der Solarmodulverbinder durch die Aufnahme in der Solarmodulverbinderöffnung vor mechanischen äußeren Beanspruchungen geschützt, insbesondere wenn der Solarmodulverbinder vollständig in der Solarmodulverbinderöffnung aufgenommen ist.

Vorzugsweise weist der Solarmodulverbinder zumindest ein Führungselement auf, welches ausgelegt ist, mit einem komplementären Führungselement der Anschlußdose in Eingriff zu gelangen, so daß der komplementäre Solarmodulverbinder der Anschlußdose entlang der Einführrichtung E lediglich mit einem, zwei oder vier vorbestimmten Azimutwinkeln gemessen in einer zur Einführrichtung E senkrecht stehenden Ebene einführbar ist. Der Azimutwinkel ist in einer zur Einführrichtung E senkrecht stehenden Ebene, insbesondere der durch den anschlußseitigen Solarmodulkörper vorgegebenen Ebene, definiert. Bevorzugt kann der komplementäre Solarmodulverbinder bzw. die Anschlußdose lediglich mit einem 2, 3 oder 4 vorbestimmten Azimutwinkeln, d.h. in einer um 360°, 180°, 120° oder 90° gedrehten Position auf dem Solarmodul angeordnet werden. Vorteilhafterweise kann die Anschlußdose relativ zur Erstreckung des Solarmoduls ausgerichtet werden, beispielsweise, um die Kanten des Anschlußdosengehäuses parallel zu den Kanten des Solarmoduls auszurichten.

### Solarmodulanordnung mit Anschlußdose gemäß einem Aspekt

Ein Aspekt der vorliegenden Erfindung betrifft eine Solarmodulanordnung mit einem erfindungsgemäßen Solarmodul und einer Anschlußdose, die Anschlußdose umfassend:
- ein Gehäuse mit einer Anordnungsseite, welche im wesentlichen formschlüssig an einen anschlußseitigen Solarmodulkörper des Solarmoduls anordenbar ist,
- zumindest einen komplementären Solarmodulverbinder mit zumindest einem Kontaktelement,
wobei das zumindest eine Kontaktelement entlang einer Verlagerungsrichtung V rückstellfähig verformbar ist und wobei der komplementäre Solarmodulverbinder entlang einer Einführrichtung E über die Anordnungsseite zumindest bereichsweise hervorsteht und ausgelegt ist, entlang der Einführrichtung E in einen Einführbereich eines Solarmodulverbinders des Solarmoduls eingeführt zu werden.

Vorteilhafterweise kann der elektrische Kontakt zwischen dem Solarmodul und der Anschlußdose in einfacher Weise durch ein bloßes Anordnen bzw. Aufstecken der Anschlußdose auf das Solarmodul hergestellt werden.

Das Gehäuse der Anschlußdose umfaßt eine Anordnungsseite, welche komplementär zu dem anschlußseitigen Solarmodulkörper ausgebildet ist, so daß die Anschlußdose im wesentlichen spaltfrei an dem anschlußseitigen Solarmodulkörper angeordnet werden kann. Der Begriff "spaltfrei" bedeutet, daß nach dem Anordnen der Anschlußdose an dem Solarmodul lediglich bereichsweise ein Spalt zwischen der Anordnungsseite des Gehäuses der Anschlußdose und dem anschlußseitigen Solarmodulkörper besteht. Weiterhin bedeutet "spaltfrei", daß der bestehende Spalt klein genug ist, so daß der Spalt mittels einer Dichtmasse bzw. eines Klebemittels geschlossen werden kann. Insbesondere kann die Spaltbreite weniger als 5 mm, weniger als 3 mm, weniger als 1 mm, weiter bevorzugt weniger als 0,5 mm betragen.

Die Anschlußdose umfaßt zumindest einen komplementären Solarmodulverbinder. Es versteht sich, daß die Anschlußdose auch eine Mehrzahl von 2, 3, 4, usw. komplementärer Solarmodulverbinder aufweisen kann. Der zumindest eine komplementäre Solarmodulverbinder kann eine Mehrzahl von beispielsweise 2, 3, 4, 5, 6, 7, 8 usw. Kontaktelementen aufweisen. Es versteht sich, daß durch das zumindest bereichsweise Einführen des zumindest einen Kontaktelements bzw. des zumindest einen komplementären Solarmodulverbinders in den Einführbereich ein elektrischer Kontakt zwischen jedem der zumindest einen Kontaktelemente des zumindest einen komplementären Solarmodulverbinders und einem zugeordneten elektrischen Leiter des Solarmodulverbinders ausbildbar ist.

Das zumindest eine Kontaktelement ist entlang einer Verlagerungsrichtung V rückstellfähig verformbar. Der Begriff "rückstellfähig" beschreibt in diesem Zusammenhang eine plastische und/oder elastische Verformbarkeit des Materials derart, daß die geometrische Verformung des rückstellfähigen Materials bzw. des Kontaktelements durch eine einwirkende Kraft entlang der Verlagerungsrichtung V im wesentlichen vollständig reversibel ist. Mit anderen Worten nimmt ein rückstellfähiges bzw. rückstellfähig verformbares Kontaktelement wieder die ursprüngliche Gestalt an bzw. Position ein, wenn die verformende Kraft nicht mehr auf das Kontaktelement wirkt. In der verformten Gestalt bzw. bei der Rückkehr in die ursprüngliche Gestalt kann das Kontaktelement eine Kraft ausüben, welche der Verlagerungsrichtung V entgegen gerichtet ist. Insbesondere ist das zumindest eine Kontaktelement derart ausgelegt, daß die Verlagerungsrichtung V entgegengesetzt zu der Richtung der Andruckkraft K gerichtet ist, mit welcher das Kontaktelement eine vorbestimmte Andruckkraft an einen zugeordneten Leiter des Solarmodulverbinders des Solarmoduls anlegen kann. Bevorzugt ist das zumindest eine Kontaktelement aus einem Metall, insbesondere einer Kupferlegierung hergestellt, so daß das zumindest eine Kontaktelement entlang der Verlagerungsrichtung V elastisch verformbar ist.

Der komplementäre Solarmodulverbinder steht entlang einer Einführrichtung E über die Anordnungsseite zumindest bereichsweise hervor, das heißt, daß das zumindest eine Kontaktelement des komplementären Solarmodulverbinders entlang der Einführrichtung über die Anordnungsseite hervorsteht. Dadurch kann das zumindest eine Kontaktelement entlang der Einführrichtung E in einen in der Solarmodulverbinderöffnung aufgenommenen bzw. angeordneten Einführbereich des Solarmodulverbinders des Solarmoduls eingeführt werden.

Vorzugsweise weist der zumindest eine komplementäre Solarmodulverbinder zumindest eine Kontaktelementhalteeinrichtung auf, wobei die zumindest eine Kontaktelementhalteeinrichtung ein zugeordnetes Kontaktelement mechanisch fixiert und als Widerlager des zugeordneten Kontaktelements gegenüber einer Verlagerung entlang der Verlagerungsrichtung V ausgebildet ist, wobei die Verlagerungsrichtung V verschieden zu der Einführrichtung E orientiert ist. Beispielsweise können die Einführrichtung E und die Verlagerungsrichtung V einen Winkel β von 60 Grad bis 90 Grad, weiter bevorzugt einen Winkel β von 75 Grad bis 90 Grad, insbesondere einen Winkel β von 85 Grad bis 90 Grad einschließen.

Vorzugsweise ist die Verlagerungsrichtung V im wesentlichen senkrecht zu der Einführrichtung E orientiert.

Bevorzugt können sich die zumindest eine Kontaktelementhalteeinrichtung und das zugeordnete Kontaktelement unmittelbar mechanisch kontaktieren. Die Kontaktelementhalteeinrichtung bzw. das durch die Kontaktelementhalteeinrichtung fixierte zugeordnete Kontaktelement sind ausgelegt, um einen zugeordneten elektrischen Leiter des Solarmodulverbinders durch zumindest bereichsweises Einführen des Kontaktelementes in den Einführbereich des Solarmodulverbinders des Solarmoduls mechanisch und elektrisch zu kontaktieren. Dabei kann das zugeordnete Kontaktelement eine Andruckkraft K entgegen der Verlagerungsrichtung V auf den elektrischen Leiter anlegen bzw. umgekehrt kann der elektrische Leiter das zugeordnete Kontaktelement entlang der Verlagerungsrichtung V aktuieren.

Bevorzugt ist jedes Kontaktelement ausgelegt, eine Andruckkraft K von größer als 0,1 N, bevorzugt größer als 1 N und insbesondere größer als 3 N an den zugeordneten elektrischen Leiter anzulegen. Die Andruckkraft ist vorzugsweise kleiner als 50 N, bevorzugt kleiner als 20 N, besonders bevorzugt kleiner als 10 N.

Vorzugsweise weist die Anschlußdose zumindest ein komplementäres Führungselement auf, welches ausgelegt ist, mit einem Führungselement des Solarmodulverbinders in Eingriff zu gelangen, so daß der komplementäre Solarmodulverbinder der Anschlußdose entlang einer Einführrichtung E lediglich mit einem, zwei oder vier vorbestimmten Azimutwinkeln - gemessen in einer zur Einführrichtung E senkrecht stehenden Ebene - einführbar ist.

Vorzugsweise umfaßt die Anschlußdose zumindest zwei Kontaktelemente, welche mittels einer Bypass-Diode miteinander elektrisch verbunden sind. Bevorzugt kann die Bypass-Diode die zwei Kontaktelemente derart verbinden, daß die Bypass-Diode elektrisch antiparallel zu der damit verbundenen Solarzelle oder Solarzellengruppe geschaltet ist. Vorteilhafterweise bewirkt die Bypass-Diode, daß der Stromfluß durch das Solarmodul an der Solarzelle bzw. Solarzellengruppe, welche eine nur geringe Leistung liefert, vorbei geleitet wird, d.h. die Anschlüsse dieser Solarzelle bzw. Solarzellengruppe des Solarmoduls werden durch die Bypass-Diode kurz geschlossen und die entsprechende Solarzelle bzw. Solarzellengruppe dadurch überbrückt. Somit liefert eine solche Solarzelle bzw. Solarzellengruppe zwar keinen Anteil mehr zur Gesamtleistung des Solarmoduls, der Gesamtstromfluß durch das Solarmodul ist jedoch im wesentlichen ungehindert und eine Beschädigung einzelner Solarzellen wird vorteilhafterweise verhindert.

Bevorzugt ist die zumindest eine Bypass-Diode der Anschlußdose mit den zugeordneten Kontaktelementen verlötet. Weiter bevorzugt ist die Bypass-Diode zusammen mit dem durch die Bypass-Diode kontaktierten Bereich der zugeordneten Kontaktelemente durch eine Dichtmasse ummantelt bzw. ist die Bypass-Diode in die Dichtmasse eingebettet. Beispielsweise kann die Bypass-Diode mit der Dichtmasse umspritzt sein. Dadurch können die Bypass-Diode und bereichsweise die Kontaktelemente vor Feuchtigkeit, insbesondere gemäß der Norm IP 67, geschützt werden. Die Dichtmasse kann aus einem Polymer, einem Plastomer oder einem Elastomer bestehen. Vorteilhafterweise ist dann das Ausgießen des gesamten Gehäuses der Anschlußdose mit Dichtmasse nach der Montage an das Solarmodul nicht mehr notwendig.

Vorzugsweise umfaßt die Anschlußdose
- zumindest ein elektrisches Anschlußkabel, wobei ein Kabelendbereich des Anschlußkabels in das Gehäuse eingeführt ist und wobei zumindest ein elektrischer Leiter des Anschlußkabels mit einem zugeordneten Kontaktelement kontaktiert, und
- zumindest ein an dem Gehäuse angeordnetes Abdichtelement, das bevorzugt flexibler als das Gehäuse ist und das den innerhalb des Gehäuses angeordneten Kabelendbereich des Anschlußkabels umfängt und derart innig mit dem Gehäuse und dem Anschlußkabel verbunden ist, daß das Innere des Gehäuses im wesentlichen vollständig feuchtigkeitsdicht von der Umgebung abgeschlossen ist.

Weiter vorzugsweise ist das zumindest eine Abdichtelement der Anschlußdose durch Spritzgießen ausgebildet. Mit anderen Worten ist das zumindest eine Abdichtelement ein Spritzgußteil.

Das Gehäuse ist im wesentlichen steif, das heißt, daß das Gehäuse aus einem Material besteht, das eine derartige Verwindungs- und/oder Zugsteifigkeit aufweist, daß die Anschlußdose üblichen Kräften bei der Montage und beim betriebsgemäßem Gebrauch stand hält. Das Abdichtelement ist bevorzugt flexibler als das Gehäuse. In anderen Worten kann das Abdichtelement "flexibel" sein, d.h. insbesondere einen anderen Elastizitätsmodul aufweisen, als das Gehäuseelement, das "starr" sein kann. Insbesondere ist der Elastizitätsmodul des Gehäuses höher als der Elastizitätsmodul des Abdichtelements. Beispielsweise beträgt der Elastizitätsmodul des Abdichtelements etwa 3 MPa und der Elastizitätsmodul des Gehäuses etwa 10000 MPa. Vorteilhafterweise wird dadurch erreicht, daß sich zum einen das Abschlußelement möglichst exakt an die Form des Gehäuses anpaßt. Beispielsweise kann hierzu das Abdichtelement weicher sein als das Gehäuse und/oder rückstellfähiger. Zum anderen kann vorteilhafterweise somit auch eine feuchtigkeitsdichte, insbesondere wasserdichte Ummantelung des Anschlußkabels und des Bereiches des Gehäuses, durch welchen das Anschlußkabel hindurchgeführt ist, ermöglicht werden. Das Abdichtelement kann das Gehäuse und das Anschlußkabel kontaktieren, insbesondere umfangen bzw. umgeben bzw. ummanteln. Der Begriff "flexibel" kann plastische und/oder elastische Verformbarkeit und/oder Rückstellfähigkeit umfassen.

Unter den Begriffen "flexibel" und "starr" werden folgende mechanische Materialeigenschaften verstanden, die im wesentlichen durch den Elastizitätsmodul E und Schermodul G quantifiziert werden können. Sowohl ein flexibles als auch ein starres Material können im wesentlichen elastisch als auch plastisch verformbar sein. Unter einer elastischen Verformung wird die geometrische Verformung eines rückstellfähigen Körpers durch eine einwirkende Kraft bzw. mechanische Spannung (Kraft pro Fläche) verstanden, die im wesentlichen vollständig reversibel ist, wenn die Kraft bzw. mechanische Spannung nicht mehr auf den Körper wirkt, so daß der Körper wieder seine ursprüngliche Gestalt annimmt. Ein flexibler Körper zeichnet sich im Gegensatz zu einem relativ dazu starren Körper, oder kurz starren Körper, dadurch aus, daß der Elastizitätsmodul E_{f} und/oder der Schermodul G_{f} des flexiblen Körpers, z.B. des Abdichtelements, kleiner sind als der Elastizitätsmodul Eₛ und/oder der Schermodul Gₛ des starren Körpers, z.B. des Gehäuses. Mit anderen Worten wird ein flexibler Körper (z.B. das Abdichtelement) bei Einwirkung einer gleich großen Kraft bzw. mechanischen Spannung stärker geometrisch verformt als ein starrer Körper (z.B. das Gehäuse).

Das Verhältnis Eₛ/E_{f} und/oder Gₛ/G_{f} größer als etwa 250, besonders bevorzugt größer als etwa 500, insbesondere größer als etwa 1000. Bevorzugt ist der Schermodul G_{f} z.B. des Abdichtelements kleiner als 10 MPa, weiter bevorzugt kleiner als 5 MPa und insbesondere kleiner als 3 MPa. Der Schermodul Gₛ des Gehäuses ist größer als 2500 MPa, bevorzugt größer als 3000 MPa, besonders bevorzugt größer als 5000 MPa und insbesondere größer als 10000 MPa.

Die innige Verbindung des Abdichtelements mit dem Gehäuse und dem Anschlußkabel ermöglicht eine Feuchtigkeitsdichtigkeit nach Industriestandard IP 67, insbesondere IP 68. Insbesondere durch ein Ausbilden des Abdichtelements, insbesondere mittels Spritzgießen während das Anschlußkabel bereits an dem Gehäuse montiert bzw. kontaktiert ist, wird die innige Verbindung des Gehäuses mit dem Abdichtelement und dem Anschlußkabel sehr einfach verwirklicht, wobei insbesondere auf eine Vielzahl von Dichtmitteln verzichtet werden kann. Gleichzeitig ist aber aufgrund der Flexibilität des Abdichtelements die Anschlußdose und damit das damit versehene Solarpaneel unanfällig gegen äußere Krafteinwirkungen. So kann beispielsweise das Anschlußkabel beispielsweise bewegt, insbesondere gebogen werden, wobei sich das flexible Abdichtelement an die Bewegung anpassen kann. Besonders vorteilhafterweise wird dadurch ein Eindringen von Feuchtigkeit in das Gehäuse der Anschlußdose auch bei einer Bewegung des Anschlußkabels verhindert.

Der Begriff "innig", wie er in dieser Anmeldung verwendet wird, kann somit insbesondere beschreiben, daß das Abdichtelement seine Ausdehnung im wesentlichen nicht verändert oder vergrößert, so daß eine mechanische Spannung zwischen dem Abdichtelement und dem Gehäuseelement entsteht. Diese mechanische Spannung kann die innige Verbindung erzeugen bzw. definieren. Die mechanische Spannung bzw. innige Verbindung kann die feuchtigkeitsdichte Verbindung des Abdichtelements mit dem Gehäuse erzeugen. Die mechanische Spannung bzw. innige Verbindung kann ermöglichen, daß das Abdichtelement fest an dem Gehäuse angeordnet ist. Ebenso kann eine innige Verbindung mit dem elektrischen Anschlußkabel herstellbar sein. Insbesondere kann das Abdichtelement mit dem Gehäuse und/oder dem Anschlußkabel zumindest partiell verschmolzen sein.

### Solarmodulverbinderanordnung gemäß einem Aspekt

Ein Aspekt der vorliegenden Erfindung betrifft eine Solarmodulverbinderanordnung mit einer Mehrzahl von Solarmodulverbindern mit
-- zumindest einem Einführbereich, in welchen zumindest ein Kontaktelement eines komplementären Solarmodulverbinders entlang einer Einführrichtung E einführbar ist,
-- zumindest einem elektrischen Leiter, welcher mit einer Solarzelle kontaktierbar ist,
-- zumindest einer Leiterhalteeinrichtung, welche einen zugeordneten elektrischen Leiter mechanisch fixiert, wobei sich der zugeordnete elektrische Leiter in einem Leiterkontaktabschnitt im wesentlichen parallel zur Einführrichtung E erstreckt,
wobei ein Solarmodulverbinder mittels eines Verbindungselementes mit einem benachbarten Solarmodulverbinder mechanisch verbunden ist. Erfindungsgemäß ist der zumindest eine elektrische Leiter als Leiterband ausgebildet, wobei die gegenüberliegenden Ränder des Leiterbandes jeweils in einer entlang der Einführrichtung orientierten Nut der zugeordneten Leiterhalteeinrichtung gehalten sind.

Vorteilhafterweise kann eine Mehrzahl von Solarmodulverbindern als Rollenware zum Durchführen eines Verfahrens zum Herstellen eines Solarmoduls in einfacher und platzsparender Weise bereitgestellt werden. Dabei können die einzelnen Solarmodulverbinder durch Trennen des Verbindungselementes von der Solarmodulverbinderanordnung getrennt bzw. vereinzelt werden. Dabei kann die Vereinzelung vor oder nach dem Herstellen des Solarmoduls bzw. der Solarmodule erfolgen. Bevorzugt kann das Verbindungselement ein weiterer elektrischer Leiter eines Solarmodulverbinders sein. Mit anderen Worten sind zwei Solarmodulverbinder mittels eines gemeinsamen elektrischen Leiters miteinander verbunden, wobei vorteilhafterweise die zwei Solarmodulverbinder mittels Durchtrennen des gemeinsamen elektrischen Leiters voneinander getrennt bzw. vereinzelt werden können.

Alternativ oder zusätzlich können die Solarmodulverbinder der Solarmodulverbinderanordnung mittels einer als Trägerschicht bzw. Trägerfolie ausgebildeten Verbinderelementes miteinander mechanisch verbunden sein. Beispielswiese können die einzelnen Solarmodulverbinder auf einer Trägerfolie aus Kunststoff befestigt sein, wobei die Vereinzelung der Solarmodulverbinder mittels Durchtrennung der Trägerfolie erfolgt. Vorteilhafterweise sind die elektrischen Leiter der Solarmodulverbinder bezüglich einer mechanischen Belastung entlastet, so daß die einzelnen elektrischen Leiter entsprechend dünn ausgeführt werden können. Weiter vorteilhafterweise kann eine Trägerschicht aus Kunststoff beim Aufrollen der Solarverbinderanordnung zu einer Rollenware die einzelnen Lagen der Rollenware voneinander trennen, so daß die einzelnen Solarmodulverbinder vor einer mechanischen Beanspruchung durch einen benachbarten Solarmodulverbinder geschützt ist.

### Verfahren zum Herstellen eines Solarmoduls gemäß einem Aspekt

Ein Aspekt der vorliegenden Erfindung betrifft ein Verfahren zum Herstellen eines Solarmoduls umfassend die Schritte:
-- Bereitstellen eines bestrahlungsseitigen Solarmodulkörpers mit zumindest einer anschlußseitig angeordneten Solarzelle,
-- Anordnen zumindest eines Solarmodulverbinders an der Anschlußseite des bestrahlungsseitigen Solarmodulkörpers, wobei der zumindest eine Solarmodulverbinder weiter umfaßt:
-- zumindest einen Einführbereich, in welchen ein komplementärer Solarmodulverbinder entlang einer Einführrichtung E einführbar ist,
-- zumindest einen elektrischen Leiter,
-- zumindest eine Leiterhalteeinrichtung, welche einen zugeordneten elektrischen Leiter mechanisch fixiert, wobei sich der zugeordnete elektrische Leiter in einem Leiterkontaktabschnitt im wesentlichen parallel zur Einführrichtung E erstreckt, wobei der zumindest eine elektrische Leiter als Leiterband ausgebildet ist und wobei die gegenüberliegenden Ränder des Leiterbandes jeweils in einer entlang der Einführrichtung orientierten Nut der zugeordneten Leiterhalteeinrichtung gehalten sind,
- Kontaktieren zumindest eines elektrischen Leiters mit einer der zumindest einen Solarzelle,
- Anordnen eines anschlußseitigen Solarmodulkörpers mit zumindest einer Solarmodulverbinderöffnung, wobei der Solarmodulverbinder zumindest bereichsweise im Bereich der Solarmodulverbinderöffnung in den anschlußseitigen Solarmodulkörper hinein ragt.

Es versteht sich, daß das Bereitstellen eines bestrahlungsseitigen Solarmodulkörpers mit zumindest einer anschlußseitig angeordneten Solarzelle auch das Herstellen bzw. Ausbilden einer Solarzelle an dem bestrahlungsseitigen Solarmodulkörper umfassen kann.

Vorteilhafterweise ist ein Solarmodul mittels des erfindungsgemäßen Verfahrens besonders einfach herzustellen, insbesondere wenn die Solarmodulverbinder als Rollenware in Form einer Solarmodulverbinderanordnung bereitgestellt werden. Das Anordnen des zumindest einen Solarmodulverbinders an die Anschlußseite des bestrahlungsseitigen Solarmodulkörpers ermöglicht eine einfache und zuverlässige elektrische Kontaktierung der zumindest einen Solarzelle des Solarmoduls, wobei vorteilhafterweise der Einführbereich des Solarmodulverbinders nach dem elektrischen Kontaktieren des Solarmodulverbinders mit der zumindest einen Solarzelle genau positioniert ist. Dadurch wird vorteilhafterweise eine definierte Position des Einführbereichs, in welchen ein komplementärer Solarmodulverbinder einer Anschlußdose entlang einer Einführrichtung E einführbar ist, relativ zu dem Solarmodul definiert, so daß der gesamte Herstellungsprozeß bezüglich des Kontaktierens des Solarmodulverbinders, des Anordnens des anschlußseitigen Solarmodulkörpers sowie des Anordnens der Anschlußdose zum Ausbilden eines Solarpaneels mittels des Solarmoduls und der Anschlußdose in einfacher Weise automatisch erfolgen kann.

Vorzugsweise umfaßt das Verfahren zum Herstellen den Schritt des Anordnens zumindest einer elektrisch isolierenden Schicht an der Anschlußseite des bestrahlungsseitigen Solarmodulkörpers bzw. an der Anschlußseite der zumindest einen Solarzelle, so daß die zumindest eine Solarzelle des Solarmoduls zumindest bereichsweise vom Äußeren bzw. der Umgebung elektrisch isoliert ist. Bevorzugt ist der vom Solarmodulverbinder bedeckte Bereich des bestrahlungsseitigen Solarmodulkörpers frei von der isolierenden Schicht. Weiter bevorzugt wird die isolierende Schicht durch Lamination aufgebracht. Weiter bevorzugt kontaktiert die isolierende Schicht zumindest bereichsweise den Solarmodulverbinder, so daß der zumindest eine Solarmodulverbinder mittels der isolierenden Schicht an dem bestrahlungsseitigen Solarmodulkörper mechanisch fixiert wird.

Demzufolge kann das Anordnen der isolierenden Schicht nach dem Anordnen und Kontaktieren des Solarmodulverbinders erfolgen. Alternativ kann das Anordnen der isolierenden Schicht auch vor dem Anordnen und Kontaktieren des Solarmodulverbinders erfolgen, wobei während des Anordnens der isolierenden Schicht an den bestrahlungsseitigen Solarmodulkörper ein Bereich frei von der isolierenden Schicht bleibt, an welchem in einen späteren Schritt der Solarmodulverbinder angeordnet und mit der zumindest einen Solarzelle des Solarmoduls elektrisch kontaktiert wird. Alternativ kann die isolierende Schicht vollflächig an den bestrahlungsseitigen Solarmodulkörper angeordnet werden, wobei die isolierende Schicht zumindest bereichsweise in einem späteren Schritt entfernt wird, um den Solarmodulverbinder mit der zumindest einen Solarzelle des Solarmoduls elektrisch zu verbinden. Vorteilhafterweise kann der Solarmodulverbinder in diesem Fall an der isolierenden Schicht angeordnet sein, so daß der Solarmodulverbinder von der zumindest einen Solarzelle bzw. dem bestrahlungsseitigen Solarmodulkörper zumindest bereichsweise durch die isolierende Schicht elektrisch isoliert ist.

### Verwendung gemäß einem Aspekt

Ein Aspekt der vorliegenden Erfindung betrifft die Verwendung einer erfindungsgemäßen Solarmodulanordnung zur Ausbildung eines Solarpaneels, wobei die Anschlußdose derart an das Solarmodul angeordnet wird, daß der komplementäre Solarmodulverbinder der Anschlußdose entlang der Einführrichtung E zumindest bereichsweise in den Solarmodulverbinder des Solarmoduls eingeführt wird, wobei jedes Kontaktelement einen zugeordneten elektrischen Leiter kontaktiert.

### Ausführungsvarianten der Verwendung

Vorzugsweise wird die Anschlußdose mittels eines Befestigungselements an dem Solarmodul befestigt. Bevorzugt kann das Befestigungselement ein Klebeelement sein, insbesondere ein doppelseitiger Klebefilm, eine Schicht Haftklebemittel oder ein Heißkleber. Das Befestigungselement kann beispielsweise an der Anordnungsseite der Anschlußdose befestigt sein, bevor die Anschlußdose an das Solarmodul angeordnet wird. Alternativ kann das Befestigungselement auch an dem anschlußseitigen Solarmodulkörper befestigt sein, bevor die Anschlußdose an dem Solarmodul bzw. an dem Befestigungselement angeordnet wird. Vorteilhafterweise kann das Befestigungselement die Verbindungsstelle zwischen Anschlußdose und Solarmodul feuchtigkeitsdicht verbinden. Insbesondere kann ein lösungsmittelbasiertes Klebemittel oder ein thermoplastisches Klebemittel in einfacher Weise eine feuchtigkeitsdichte Verbindung zwischen der Anschlußdose und dem Solarmodul ausbilden.

Vorzugsweise legt eines des zumindest einen Kontaktelements der Anschlußdose entlang der Verlagerungsrichtung V eine vorbestimmte Andruckkraft K auf einen zugeordneten elektrischen Leiter des Solarmodulverbinders an, wobei die Verlagerungsrichtung V im wesentlichen senkrecht zu der Einführrichtung orientiert ist.

### Figurenbeschreibung

Bevorzugte Ausführungsformen eines Solarmoduls, eines Solarmodulverbinders und einer Anschlußdose werden nachfolgend anhand begleitender Figuren beispielhaft beschrieben. Es zeigt:
- Figur 1: eine perspektivische Schnittansicht einer Ausführungsform eines Solarmoduls,
- Figur 2: eine Detailansicht des in Figur 1 gezeigten Solarmoduls,
- Figur 3: eine Schnittansicht durch das in den Figuren 1 und 2 gezeigten Solarmoduls sowie durch eine Ausführungsform einer Anschlußdose,
- Figur 4: die in der Figur 3 gezeigte Anschlußdose in der Betriebsposition,
- Figur 5: eine perspektivischen Schnittansicht einer Ausführungsform einer Anschlußdose und eines Solarmoduls,
- Figur 6: eine perspektivische Ansicht eines Solarmodulverbinders und eines komplementären Solarmodulverbinders,
- Figur 7: eine perspektivischen Schnittansicht eines Solarpaneels mit einem Solarmodul und einer daran angeordneten Anschlußdose, und
- Figur 8: eine perspektivischen Schnittansicht einer Anschlußdose.

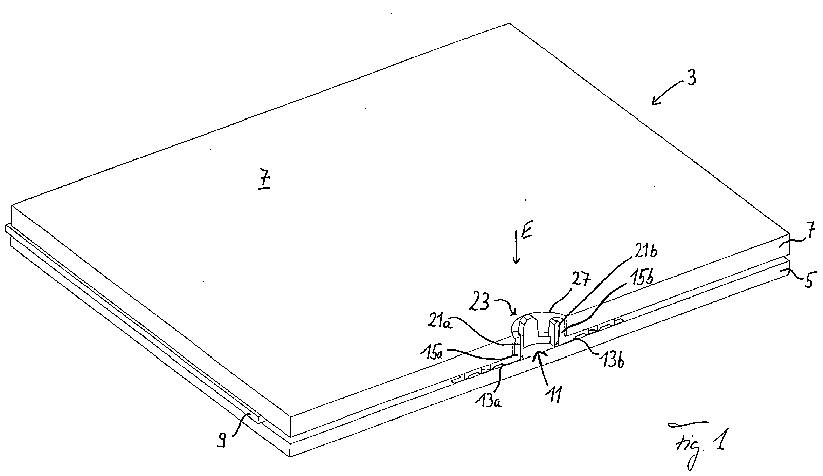

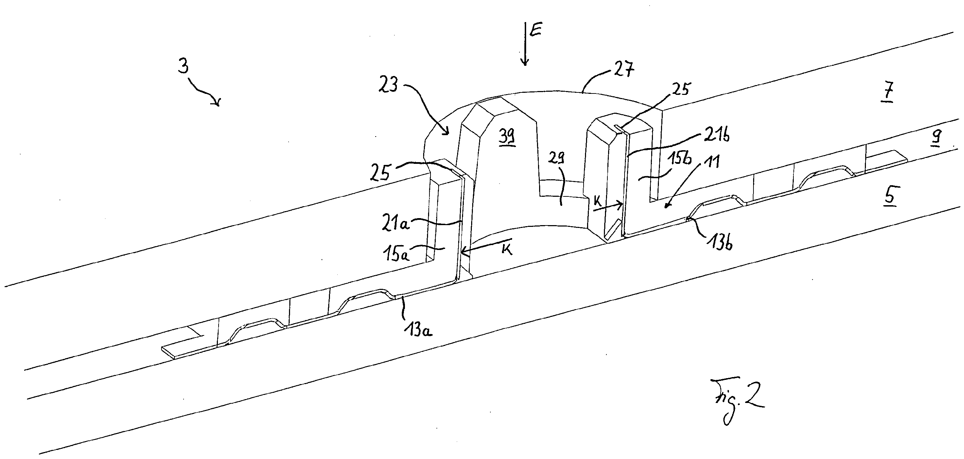

Die **Figuren 1** **und** **2** zeigen eine perspektivische Schnittansicht eines Solarmoduls 3 mit einem bestrahlungsseitigen Solarmodulkörper 5 und einem anschlußseitigen Solarmodulkörper 7. Der bestrahlungsseitige Solarmodulkörper 5 umfaßt ein transparentes bzw. lichtdurchlässiges Material, wie beispielsweise Glas. Insbesondere kann der bestrahlungsseitige Solarmodulkörper 5 aus einer Glasplatte bestehen. An dem bestrahlungsseitigen Solarmodulkörper 5 ist zumindest eine Solarzelle (nicht gezeigt) angeordnet, wobei die zumindest eine Solarzelle zwischen dem bestrahlungsseitigen Solarmodulkörper 5 und dem anschlußseitigen Solarmodulkörper 7 angeordnet ist. Mit anderen Worten ist die Solarzelle an der Anschlußseite an dem bestrahlungsseitigen Solarmodulkörper 5 angeordnet, während die der Anschlußseite entgegengesetzte Seite des bestrahlungsseitigen Solarmodulkörpers 5 frei von Solarzellen ist und bei betriebsgemäßem Gebrauch des Solarmoduls zur Lichtquelle hin gerichtet ist.

Nach dem Anordnen der Solarzelle an dem bestrahlungsseitigen Solarmodulkörper 5 kann eine elektrisch isolierende Schicht 9 an der Anschlußseite an dem bestrahlungsseitigen Solarmodulkörper 5 bzw. an der Solarzelle ausgebildet werden, um die an dem bestrahlungsseitigen Solarmodulkörper 5 angeordnete Solarzelle elektrisch zu isolieren und vor mechanischen und/oder chemischen Einflüssen zu schützen. Mit anderen Worten kann zwischen dem bestrahlungsseitigen Solarmodulkörper 5 und dem anschlußseitigen Solarmodulkörper 7 zumindest bereichsweise die isolierende Schicht 9 ausgebildet sein.

Das in den Figuren 1 und 2 gezeigte Solarmodul 3 umfaßt weiter einen Solarmodulverbinder 11 mit zwei elektrischen Leitern 13a, 13b. Die elektrischen Leiter 13a, 13b können unmittelbar oder mittelbar mit einem Anschlußbereich einer zugeordneten der zumindest einen Solarzelle des Solarmoduls 3 elektrisch kontaktiert sein. Die elektrischen Leiter 13a, 13b sind zumindest bereichsweise zwischen dem bestrahlungsseitigen Solarmodulkörper 5 und dem anschlußseitigen Solarmodulkörper 7 des Solarmoduls 3 angeordnet. Dabei können die elektrischen Leiter 13a, 13b zumindest bereichsweise unmittelbar an dem bestrahlungsseitigen Solarmodulkörper 5 angeordnet sein. Bevorzugt können die an dem bestrahlungsseitigen Solarmodulkörper 5 angeordneten elektrischen Leiter 13a, 13b und die an dem bestrahlungsseitigen Solarmodulkörper 5 angeordnete zumindest eine Solarzelle mittels eines Luftspaltes elektrisch voneinander isoliert sein. Weiter bevorzugt können die elektrischen Leiter 13a, 13b zumindest bereichsweise mittels der elektrisch isolierenden Schicht 9 von der zumindest einen Solarzelle des Solarmoduls 3 elektrisch isoliert sein.

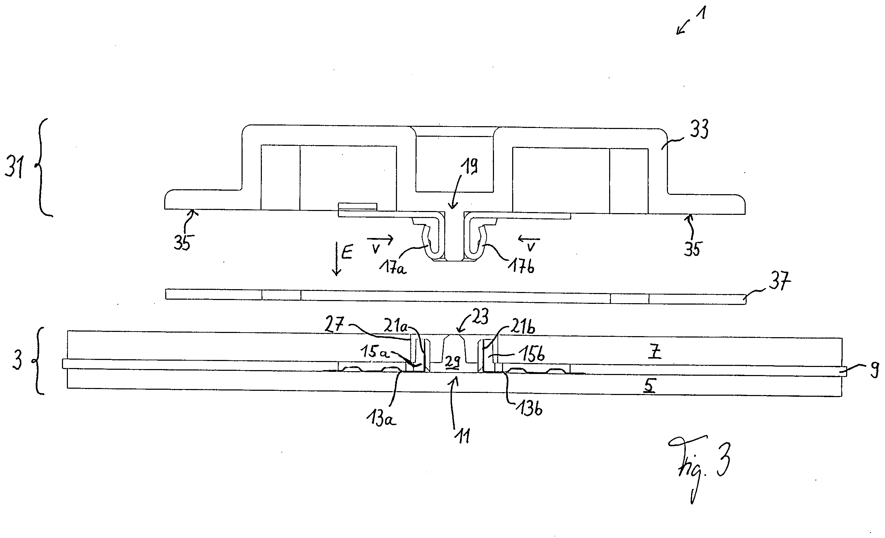

Die in den Figuren 1 und 2 gezeigte bevorzugte Ausführungsform des Solarmodulverbinders 11 umfaßt zwei Leiterhalteeinrichtungen 15a, 15b, welche jeweils einen zugeordneten elektrischen Leiter 13a, 13b mechanisch fixieren. Dabei sind die elektrischen Leiter 13a, 13b, welche sich in dem an dem bestrahlungsseitigen Solarmodulkörper 5 angeordneten Bereich der elektrischen Leiter 13a, 13b im wesentlichen parallel zum bestrahlungsseitigen Solarmodulkörper 5 erstrecken, im Bereich der Leiterhalteeinrichtungen 15a, 15b derart umgebogen, daß sich die elektrischen Leiter 13a, 13b von dem bestrahlungsseitigen Solarmodulkörper 5 weggerichtet erstrecken. Insbesondere können sich die elektrischen Leiter 13a, 13b im Bereich der Leiterhalteeinrichtungen 15a, 15b im wesentlichen senkrecht zum bestrahlungsseitigen Solarmodulkörper 5 erstrecken. Die im Bereich der Leiterhalteeinrichtung 15a, 15b umgebogenen elektrischen Leiter 13a, 13b sind dazu ausgelegt, mit einem Kontaktelement 17a, 17b eines komplementären Solarmodulverbinders 19 elektrisch zu kontaktieren (siehe auch Fig. 3). Mit anderen Worten können die umgebogenen, von dem bestrahlungsseitigen Solarmodulkörper 5 weggerichteten Bereiche bzw. Abschnitte der elektrischen Leiter 13a, 13b auch als Leiterkontaktabschnitt 21a, 21b bezeichnet werden.

Die Leiterhalteeinrichtungen 15a, 15b sowie die Leiterkontaktabschnitte 21a, 21b können einen Einführbereich 23 des Solarmodulverbinders 11 definieren, in welchen die Kontaktelemente 17a, 17b des komplementären Solarmodulverbinders 19 entlang einer Einführrichtung E einführbar sind. Die Leiterkontaktabschnitte 21a, 21b der elektrischen Leiter 13a, 13b erstrecken sich ebenfalls im wesentlichen entlang der Einführrichtung E. Die Leiterkontaktabschnitte 21a, 21b können als flache Leiterbänder ausgebildet sein. Die elektrischen Leiter 13a, 13b sind vollständig als flache Leiterbänder ausgebildet. Die Leiterkontaktabschnitte 21a, 21b der elektrischen Leiter 13a, 13b werden jeweils durch eine zugeordnete Leiterhalteeinrichtung 15a, 15b derart mechanisch fixiert, so daß die Leiterkontaktabschnitte 21a, 21b sich entlang der Einführrichtung E erstrecken. Die gegenüberliegenden Ränder der Leiterkontaktabschnitte 21a, 21b bzw. der elektrischen Leiter 13a, 13b sind in zwei gegenüberliegenden und entlang der Einführrichtung E orientierten Nuten 25a, 25b der zugeordneten Leiterhalteeinrichtung 15a, 15b eingeführt und gehalten.

Die Leiterkontaktabschnitte 21a, 21b der elektrischen Leiter 13a, 13b liegen zumindest bereichsweise flächig an der zugeordneten Leiterhalteeinrichtung 15a, 15b an. Die Leiterhalteeinrichtungen 15a, 15b sind somit als Widerlager des zugeordneten Leiterkontaktabschnitts 21a, 21b bzw. des zugeordneten elektrischen Leiters 13a, 13b gegenüber einer Andruckkraft K ausgebildet, welche in einer Andruckrichtung auf den zugeordneten Leiterkontaktabschnitt 21a, 21b bzw. auf den zugeordneten elektrischen Leiter 13a, 13b wirkt, welche verschieden von der Einführrichtung E ist. Bevorzugt ist die Leiterhalteeinrichtung 15a, 15b ausgelegt, um als Widerlager für eine Andruckkraft K zu dienen, welche im wesentlichen senkrecht zu der Einführrichtung E auf den zugeordneten Leiterkontaktabschnitt 21a, 21b wirkt.

Der anschlußseitige Solarmodulkörper 7 weist eine Solarmodulverbinderöffnung 27 auf, welche einen Zugang zu dem Solarmodulverbinder 11 ermöglicht. Die Solarmodulverbinderöffnung 27 kann beispielsweise als rechteckige oder kreisförmige Öffnung in dem anschlußseitigen Solarmodulkörper 7 ausgebildet sein. Bevorzugt ist die Solarmodulverbinderöffnung 27 als Bohrung in dem anschlußseitigen Solarmodulkörper 7 ausgebildet. Dementsprechend können die Leiterhalteeinrichtungen 15a, 15b entsprechend der Gestalt der Solarmodulverbinderöffnung 27 angeordnet sein, beispielsweise können die Leiterhalteeinrichtungen 15a, 15b kreisförmig angeordnet sein. Bevorzugt können die Leiterhalteeinrichtungen 15a, 15b alleine oder mit weiteren Elementen komplementär zu der Solarmodulverbinderöffnung 27 ausgebildet sein, so daß die Solarmodulverbinderöffnung 27 beim Anordnen an dem anschlußseitigen Solarmodulkörper 7 an die weiteren Bauteile des Solarmoduls 3 im wesentlichen formschlüssig mit den Leiterhalteeinrichtungen 15a, 15b verbunden sind. Vorteilhafterweise kann der Solarmodulverbinder 11 in dieser Weise als Positionierungselement für die relative Positionierung an dem anschlußseitigen Solarmodulkörper 7 gegenüber dem bestrahlungsseitigen Solarmodulkörper 5 dienen.

Bevorzugt sind die Leiterhalteeinrichtungen 15a, 15b des Solarmodulverbinders 11 nach dem Anordnen an dem anschlußseitigen Solarmodulkörper 7 vollständig in der Solarmodulverbinderöffnung 27 aufgenommen. Mit anderen Worten steht der Solarmodulverbinder 11 nicht entgegen der Einführrichtung E über den anschlußseitigen Solarmodulkörper 7 hervor. Vorteilhafterweise ist der Solarmodulverbinder 11 dadurch mittels dem anschlußseitigen Solarmodulkörper 7 vor mechanischen äußeren Beanspruchungen geschützt.

Bevorzugt sind die Leiterhalteeinrichtungen 15a, 15b derart ausgebildet, daß die Leiterhalteeinrichtungen 15a, 15b zumindest bereichsweise zwischen dem bestrahlungsseitigen Solarmodulkörper 5 und dem anschlußseitigen Solarmodulkörper 7 angeordnet. Weiter bevorzugt können die Leiterhalteeinrichtungen 15a, 15b mit einem Leiterhalteeinrichtungsbefestigungselement 29 verbunden sein, welches zumindest bereichsweise zwischen dem bestrahlungsseitigen Solarmodulkörper 5 und dem anschlußseitigen Solarmodulkörper 7 angeordnet ist. Besonders bevorzugt verbindet das Leiterhalteeinrichtungsbefestigungselement 29 alle Leiterhalteeinrichtungen 15a, 15b des Solarmodulverbinders 11, um diese mittels einer zumindest bereichsweisen Anordnung zwischen dem bestrahlungsseitigen Solarmodulkörper 5 und dem anschlußseitigen Solarmodulkörper 7 räumlich zu fixieren. Vorteilhafterweise können die Leiterhalteeinrichtungen 15a, 15b in einfacher Weise räumlich fixiert werden, insbesondere gegenüber einer Verlagerung entgegen der Einführrichtung E, da die Leiterhalteeinrichtungen 15a, 15b bzw. das Leiterhalteeinrichtungsbefestigungselement 29 durch eine zumindest bereichsweise Anordnung zwischen dem bestrahlungsseitigen Solarmodulkörper 5 und dem anschlußseitigen Solarmodulkörper 7 des Solarmoduls 3 festgelegt bzw. festgeklemmt ist.

Die Leiterhalteeinrichtungen 15a, 15b bzw. das Leiterhalteeinrichtungsbefestigungselement 29 kann vorzugsweise aus einem Polymer bzw. einem Elastomer ausgebildet sein. Insbesondere können die elektrischen Leiter 13a, 13b bzw. die Leiterkontaktabschnitte 21a, 21b zumindest bereichsweise von der Leiterhalteeinrichtung 15a, 15b bzw. von dem Leiterhalteeinrichtungsbefestigungselement 29 umschlossen sein. Bevorzugt weisen die elektrischen Leiter 13a, 13b und/oder die Leiterkontaktabschnitte 21a, 21b in dem Bereich, welcher durch ein Polymer oder ein Elastomer der Leiterhalteeinrichtungen 15a, 15b bzw. des Leiterhalteeinrichtungsbefestigungselements 29 umschlossen ist, Ausbuchtungen bzw. Einbuchtungen auf, wodurch vorteilhafterweise eine Verlagerung der elektrischen Leiter 13a, 13b bzw. der Leiterkontaktabschnitte 21a, 21b gegenüber dem umgebenden Polymer bzw. Elastomer verhindert wird.

Bevorzugt sind die Leiterkontaktabschnitte 21a, 21b einstückig mit dem elektrischen Leitern 13a, 13b ausgebildet. Vorteilhafterweise kann es ausreichend sein, daß in diesem Fall ein elektrischer Leiter 13a, 13b lediglich umgebogen wird, so daß sich der elektrische Leiter 13a, 13b in einem Bereich, welcher dann zum Leiterkontaktabschnitt 21a, 21b wird, parallel zur Einführrichtung E erstreckt. Es versteht sich, daß alternativ die Leiterkontaktabschnitte 21a, 21b getrennt von den elektrischen Leitern 13a, 13b ausgebildet sein können, wobei die Leiterkontaktabschnitte 21a, 21b mit einem zugeordneten elektrischen Leiter 13a, 13b elektrisch und mechanisch, beispielsweise durch Löten, Schweißen, Crimpen, Kleben, Bördeln, Schrauben, Nieten usw., verbunden sind.

Die in den Figuren 1 bis 3 gezeigte bevorzugte Ausführungsform des Solarmodulverbinders 11 umfaßt zwei Leiterkontaktabschnitte 21a, 21b bzw. zwei elektrische Leiter 13a, 13b, welche in zugeordneten Leiterhalteeinrichtungen 14a, 15b fixiert sind, wobei die Leiterhalteeinrichtungen 15a, 15b den Einführbereich 23 definieren. Dementsprechend ist der Solarmodulverbinder 11 ausgelegt, um mit einem komplementären Solarmodulverbinder 19 zu kontaktieren, welcher entsprechend der Anzahl der Leiterkontaktabschnitte 21a, 21b zwei Kontaktelemente 17a, 17b aufweist, welche entlang der Einführrichtung E zumindest bereichsweise in den Einführbereich 23 einführbar sind, um mit einem zugeordneten Leiterkontaktabschnitt 21a, 21b des Solarmodulverbinders 11 zu kontaktieren. Es versteht sich, daß die Anzahl der Leiterkontaktabschnitte 21a, 21b in der gezeigten Ausführungsform lediglich beispielhaft gewählt ist. Alternativ kann der Solarmodulverbinder 11 eine beliebige Anzahl von Leiterhalteeinrichtungen 15a, 15b bzw. Leiterkontaktabschnitten 21a, 21b umfassen. Beispielsweise kann der Solarmodulverbinder 11 1, 2, 3, 4, 5, 6, 7, 8, 9, 10, usw. Leiterkontaktabschnitte umfassen. Dementsprechend kann der komplementäre Solarmodulverbinder 19, welcher ausgelegt ist, entlang der Einführrichtung E in den Solarmodulverbinder 11 eingeführt zu werden, ebenfalls eine entsprechende Anzahl von Kontaktelementen 17a, 17b umfassen.

Figur 3 zeigt die in den Figuren 1 und 2 gezeigte bevorzugte Ausführungsform des Solarmoduls 3 und eine bevorzugte Ausführungsform einer Anschlußdose 31, welche ausgelegt ist an dem Solarmodul 3 angeordnet zu sein. Die Anschlußdose 31 umfaßt ein Gehäuse 33 mit einer Anordnungsseite 35, wobei die Anordnungsseite 35 im wesentlichen eben ausgebildet ist, so daß die Anordnungsseite 35 im wesentlichen formschlüssig an dem anschlußseitigen Solarmodulkörper 7 des Solarmoduls 3 angeordnet werden kann. Um die Anschlußdose 31 insbesondere feuchtigkeitsdicht mit dem Solarmodul 3 zu verbinden, ist ein Befestigungselement 37 vorgesehen, bevorzugt ein Klebeelement 37, um die Anschlußdose 31 mit dem Solarmodul 3 zu verkleben. Bevorzugt ist das Klebeelement 37 ein doppelseitiger Klebefilm, welcher an der Anordnungsseite 35 der Anschlußdose 31 befestigt sein kann, bevor die Anschlußdose 31 an das Solarmodul 3 angeordnet wird. Alternativ kann auch ein Haftklebemittel oder ein Heißklebemittel als bevorzugtes Befestigungselement 37 verwendet werden.

Die Anschlußdose 31 umfaßt weiter einen komplementären Solarmodulverbinder 19 mit zwei Kontaktelementen 17a, 17b. Es versteht sich, daß der komplementäre Solarmodulverbinder 19 eine beliebige Anzahl von Kontaktelementen aufweisen kann. Zumindest ein Kontaktelement 17a, 17b des komplementären Solarmodulverbinders 19 ist entlang einer Verlagerungsrichtung V rückstellfähig verformbar. Bevorzugt sind die Kontaktelemente 17a, 17b aus einem Metall, insbesondere einer Kupferlegierung hergestellt, so daß zumindest ein Kontaktelement 17a, 17b entlang der Verlagerungsrichtung V elastisch verformbar ist. Beim Anordnen der in der Figur 3 gezeigten bevorzugten Ausführungsform der Anschlußdose 31 an das Solarmodul 3 werden die Kontaktelemente 17a, 17b des komplementären Solarmodulverbinders 19 der Anschlußdose 31 entlang der Einführrichtung E in den Einführbereich 23 des Solarmodulverbinders 11 des Solarmoduls 3 eingeführt. Da der Solarmodulverbinder 11 des in Figur 3 gezeigten bevorzugten Solarmoduls 3 nicht über den anschlußseitigen Solarmodulkörper 7 des Solarmoduls 3 hervorsteht, steht der komplementäre Solarmodulverbinder 19 der Anschlußdose 31 entlang der Einführrichtung E über die Anordnungsseite 35 hervor.

Bevorzugt weist der Solarmodulverbinder 11 zumindest ein Führungselement 39 auf, welches ausgelegt ist, mit einem komplementären Führungselement 41 der Anschlußdose 31 in Eingriff zu gelangen, so daß der komplementäre Solarmodulverbinder 19 und damit die Anschlußdose 31 entlang der Einführrichtung E lediglich mit vorbestimmten Azimutwinkeln einführbar ist. Der Azimutwinkel wird dabei in einer zur Einführrichtung E senkrecht stehenden Ebene, insbesondere der durch der anschlußseitige Solarmodulkörper 7 vorgegebenen Ebene, definiert. Bevorzugt kann der komplementäre Solarmodulverbinder 19 bzw. die Anschlußdose 31 lediglich mit einem 2, 3 oder 4 vorbestimmten Azimutwinkeln, d.h. in einer um 360°, 180°, 120° oder 90° gedrehten Position auf dem Solarmodul 3 angeordnet werden.

Nach dem Anordnen der Anschlußdose 31 an das Solarmodul 3 bzw. nach dem Befestigen der Anschlußdose 31 mittels des Befestigungselements 37 an dem Solarmodul 3 befinden sind die Anschlußdose 31 und das Solarmodul 3 in einer Betriebsposition. Mit anderen Worten bilden das Solarmodul 3 und die Anschlußdose 31 in der Betriebsposition ein funktionsfähiges Solarpaneel 1 aus.

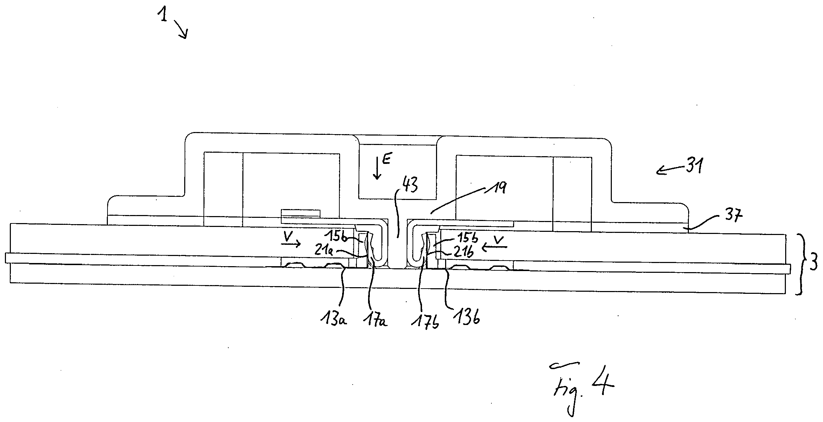

Figur 4 zeigt die in der Figur 3 gezeigte Ausführungsform der Anschlußdose 31 in der Betriebsposition. Die Anschlußdose 31 ist mittels des Befestigungselements 37 an dem Solarmodul 3 befestigt. Dabei kontaktieren die Kontaktelemente 17a, 17b die zugeordneten elektrischen Leiter 13a, 13b des Solarmoduls 3 im Bereich der Leiterkontaktabschnitte 21a, 21b. Durch das Anordnen und Kontaktieren der Anschlußdose 31 mit dem Solarmodul 3 wird ein Solarpaneel 1 ausgebildet.

Die Kontaktelemente 17a, 17b des komplementären Solarmodulverbinders 19 sind durch eine Kontaktelementhalteeinrichtung 43 in ihrer räumlichen Position zumindest bereichsweise fixiert. Die Kontaktelementhalteeinrichtung 47 dient als Widerlager der Kontaktelemente 17a, 17b gegenüber einer translatorischen Verlagerung entlang der Verlagerungsrichtung V. Dazu können die Kontaktelementhalteeinrichtung 43 und die Kontaktelemente 17a, 17b unmittelbar miteinander mechanisch kontaktieren. Es versteht sich, daß die Kontaktelemente 17a, 17b auch mittelbar mit der Kontaktelementhalteeinrichtung 43, beispielsweise mittels eines Klebemittels, verbunden sein können. Die mittels der Kontaktelementhalteeinrichtung 43 in den komplementären Solarmodulverbinder 19 mechanisch fixierten Kontaktelemente 17a, 17b sind zumindest bereichsweise jeweils entlang einer Verlagerungsrichtung V verlagerbar bzw. verformbar. Dabei steht die Verlagerungsrichtung V jeweils in etwa senkrecht zur Einführrichtung E. Es versteht sich jedoch, daß die im folgenden beschriebenen technischen Effekte auch erreicht werden, wenn der zwischen der Einführrichtung E und der Verlagerungsrichtung V eingeschlossene Winkel β zwischen etwa 60° bis etwa 90° beträgt.

Die Kontaktelemente 17a, 17b sind in dem entlang der Verlagerungsrichtung V verlagerbaren Bereich rückstellfähig ausgebildet. Eine bereichsweise Verlagerung eines der Kontaktelemente 17a, 17b entlang der Verlagerungsrichtung V bewirkt eine Rückstellkraft entgegen der Verlagerungsrichtung V. In der in Figur 4 gezeigten Betriebsposition werden die Kontaktelemente 17a, 17b jeweils durch einen zugeordneten elektrischen Leiter 13a, 13b, welcher jeweils durch eine Leiterhalteeinrichtung 15a, 15b gehalten wird, entgegen der Verlagerungsrichtung V aktuiert. Bedingt durch die Rückstellkraft der Kontaktelemente 17a, 17b legen diese eine vorbestimmte Andruckkraft K entgegen der Verlagerungsrichtung V auf die zugeordneten elektrischen Leiter 13a, 13b an. Die von dem Kontaktelementen 17a, 17b jeweils auf die zugeordneten elektrischen Leiter 13a, 13b ausgeübte Andruckkraft K ist vorzugsweise größer als 0,1 N, weiter bevorzugt größer als 1 N und insbesondere größer als 3 N.

Vorteilhafterweise weist die elektrische Verbindung zwischen den elektrischen Leitern 13a, 13b und den zugeordneten Kontaktelementen 17a, 17b einen geringen elektrischen Übergangswiderstand auf. Weiter vorteilhafterweise ist die elektrische Verbindung zwischen den Kontaktelementen 17a, 17b und den zugeordneten elektrischen Leitern 13a, 13b auf Grund der rückstellfähigen Ausbildung der Kontaktelemente 17a, 17b gegenüber Vibrationen unempfindlich.

Es versteht sich, daß in Abwandlung der gezeigten bevorzugten Ausführungsform eine Mehrzahl von Kontaktelementhalteeinrichtungen bereitgestellt werden kann, welche jeweils ein zugeordnetes Kontaktelement 17a, 17b mechanisch fixiert. Besonders bevorzugt wird jedoch nur eine einzige Kontaktelementhalteeinrichtung 43 bereitgestellt, um welche herum eine Mehrzahl von Kontaktelementen 17a, 17b, insbesondere eine geradzahlige Mehrzahl von Kontaktelementen 17a, 17b, angeordnet ist, wobei die Kontaktelemente 17a, 17b jeweils paarweise gegenüberliegend an der Kontaktelementhalteeinrichtung 43 angeordnet sein können. Vorteilhafterweise sind die Verlagerungsrichtungen der einzelnen Kontaktelemente 17a, 17b in diesem Fall paarweise entgegengesetzt orientiert, so daß sich die auf die Kontaktelemente 17a, 17b wirkenden Kräfte im Bereich der Kontaktelementhalteeinrichtung 43 gegenseitig aufheben, wodurch diese vorteilhafterweise mechanisch schwächer ausgeführt werden kann.

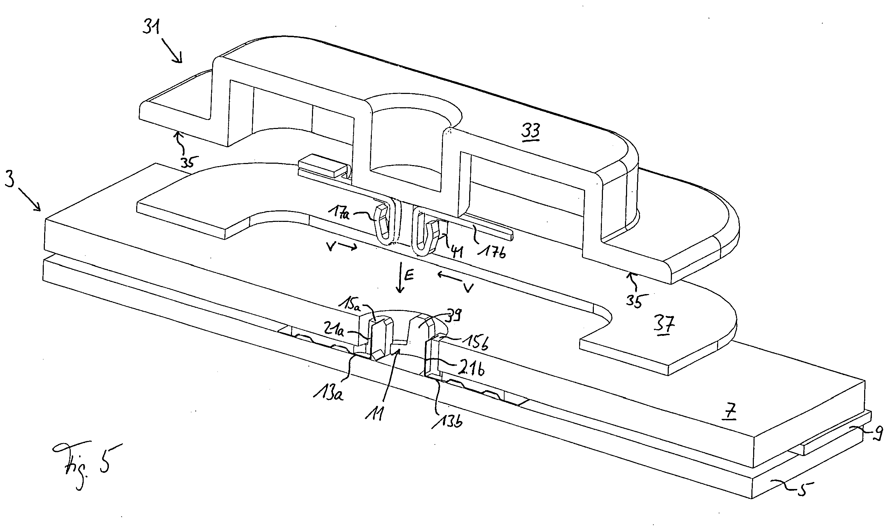

Figur 5 zeigt eine weitere Ausführungsform einer Anschlußdose 31 und ein Solarmodul 3 in einer perspektivischen Schnittansicht. Die in der Figur 5 gezeigte Ausführungsform des Solarmoduls 3 entspricht der in den Figuren 1 bis 4 gezeigten Ausführungsform, weshalb gleiche Bauteile mit denselben Bezugsziffern bezeichnet sind. Die in der Figur 5 gezeigte Anschlußdose 31 umfaßt ein Gehäuse 33 mit einer Anordnungsseite 35, wobei das Gehäuse 33 ausgelegt ist, um mittels des doppelseitigen Klebefilms 37 als bevorzugtes Befestigungselement 37 an dem anschlußseitigen Solarmodulkörper 7 des Solarmoduls 3 befestigt zu werden.

Die Anschlußdose 31 umfaßt weiter einen komplementären Solarmodulverbinder 19 mit zwei Kontaktelementen 17a, 17b, wobei die zwei Kontaktelemente 17a, 17b entgegen der in den Figuren 3 und 4 gezeigten Ausführungsform nicht mittels einer Kontaktelementhalteeinrichtung 43 mechanisch fixiert werden. Die Kontaktelemente 17a, 17b sind bereichsweise entlang einer Verlagerungsrichtung V rückstellfähig bzw. elastisch verlagerbar bzw. verformbar. Bevorzugt sind die Kontaktelemente 17a, 17b außerhalb des verlagerbaren Bereiches derart verstärkt ausgeführt, daß die Kontaktelemente 17a, 17b außerhalb des verlagerbaren Bereiches im wesentlichen nicht verformbar bzw. verlagerbar sind. Beispielsweise könnten die Kontaktelemente 17a, 17b außerhalb des verlagerbaren Bereiches eine größere Materialfestigkeit und/oder größere Materialdicke aufweisen. Vorteilhafterweise ist es dadurch nicht notwendig, eine Kontaktelementhalteeinrichtung auszubilden.

In der in Figur 5 gezeigten Ausführungsform bilden die Kontaktelemente 17a, 17b zusammen mit einem komplementären Führungselement 41 den komplementären Solarmodulverbinder 19 aus. Das komplementäre Führungselement 41 der Anschlußdose 31 ist derart ausgebildet und angeordnet, um mit einem Führungselement 39 des Solarmodulverbinders 11 des Solarmoduls 3 in Eingriff zu gelangen, so daß die Anschlußdose 31 entlang der Einführrichtung E lediglich mit vorbestimmten Azimutwinkeln einführbar ist.

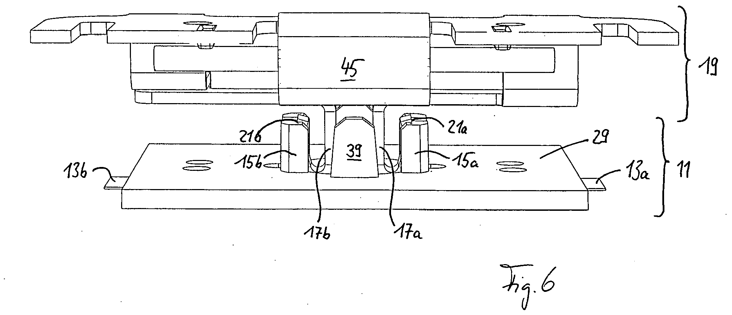

Figur 6 zeigt eine perspektivische Ansicht einer Ausführungsform eines Solarmodulverbinders 11 und eines komplementären Solarmodulverbinders 19. Der Solarmodulverbinder 11 umfaßt zwei elektrische Leiter 13a, 13b, welche jeweils durch eine zugeordnete Leiterhalteeinrichtung 15a, 15b mechanisch fixiert sind. Weiter umfaßt der Solarmodulverbinder 11 ein Führungselement 39, welches ausgelegt ist mit einem komplementären Führungselement (nicht gezeigt) in Eingriff zu gelangen. Die Leiterhalteeinrichtungen 15a, 15b sowie das Führungselement 39 sind mittels eines Leiterhalteeinrichtungsbefestigungselements 29 miteinander mechanisch verbunden. Vorzugsweise können die Leiterhalteeinrichtungen 15a, 15b, das Führungselement 39 sowie das Leiterhalteeinrichtungsbefestigungselement 29 einstückig ausgebildet sein, insbesondere durch ein Spritzgußteil aus einem thermoplastischen Polymer.

Der komplementäre Solarmodulverbinder 19 umfaßt zwei Kontaktelemente 17a, 17b, welche in der gezeigten Position jeweils einen zugeordneten Leiterkontaktabschnitt 21a, 21b des zugeordneten elektrischen Leiters 13a, 13b des Solarmodulverbinders 11 kontaktieren. Die Kontaktelemente 17a, 17b des komplementären Solarmodulverbinders 19 sind mittels einer Bypass-Diode 45 miteinander elektrisch verbunden. Die Bypass-Diode 45 kann beispielsweise eine Schottky-Diode oder eine Zener-Diode sein. Die Bypass-Diode 45 ist ausgelegt, einen elektrischen Kurzschluß zwischen den Kontaktelementen 17a, 17b herzustellen, wenn zwischen den Kontaktelementen 17a, 17b eine vorbestimmte elektrische Spannung überschritten wird.

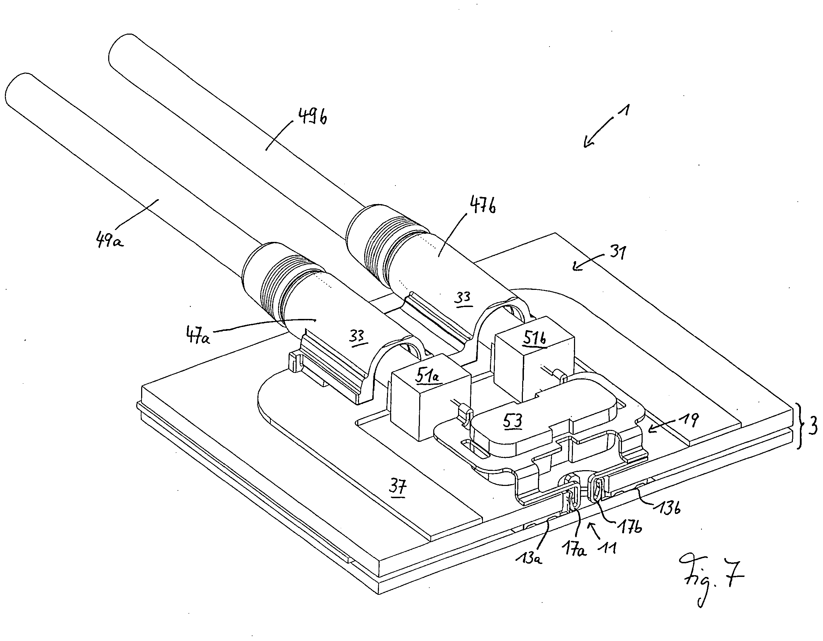

Figur 7 zeigt ein Solarpaneel 1 mit einem Solarmodul 3 und einer daran angeordneten Anschlußdose 31 in einer perspektivischen Schnittansicht. Die Anschlußdose 31 ist mit einem teilweise abgenommenen Gehäuse 33 gezeigt. Dargestellt sind zwei Anschlußkabeldurchführbereiche 47a, 47b des Gehäuses 33, wobei jeweils ein zugeordnetes Anschlußkabel 49a, 49b durch die Anschlußkabeldurchführbereiche 47a, 47b in das Innere des Gehäuses 33 der Anschlußdose 31 eingeführt ist. Jedes der Anschlußkabel 49a, 49b umfaßt zumindest einen elektrischen Leiter (nicht gezeigt), welcher mit einem zugeordneten Kontaktelement 17a, 17b des komplementären Solarmodulverbinders 19 elektrisch kontaktiert ist.

Die Anschlußdose 31 weist bevorzugt zwei Anschlußkabel 49a, 49b und zwei Anschlußkabeldurchführbereiche 47a, 47b auf, wobei jedes Anschlußkabel 49a, 49b durch einen zugeordneten Anschlußkabeldurchführbereich 47a, 47b in das Innere des Gehäuses 33 eingeführt ist. Es versteht sich, daß die zwei Anschlußkabel 49a, 49b ebenfalls durch einen gemeinsamen einzigen Anschlußkabeldurchführbereich in das Gehäuse 33 eingeführt sein können. Weiter versteht sich, daß die Anschlußdose 31 lediglich ein Anschlußkabel aufweisen kann.

Die Anschlußdose 31 kann weiter zumindest ein Abdichtelement 51a, 51b aufweisen, welches jeweils einen Kabelendbereich des zumindest einen Anschlußkabels, bevorzugt der zwei Anschlußkabel 49a, 49b umfängt und derart innig mit dem Gehäuse 31 und jeweils einem der Anschlußkabel 49a, 49b verbunden ist, daß das Innere des Gehäuses 33 im wesentlichen vollständig feuchtigkeitsdicht (insbesondere nach den Normen IP 67 oder IP 68) von der Umgebung bzw. dem Äußeren abgeschlossen ist. Dabei kann das Abdichtelement 51a, 51b flexibler als das Gehäuse 33 sein.

Bevorzugt ist das Abdichtelement 51a, 51b innerhalb des Gehäuses 33, insbesondere im Bereich der Anschlußkabeldurchführbereiche 47a, 47b an dem Kabelendbereich des Anschlußkabels 49a, 49b angeordnet. Besonders bevorzugt kann das Abdichtelement 51a, 51b durch Spritzgießen ausgebildet werden. Dazu kann die notwendige Anzahl von Anschlußkabeln 49a, 49b durch die Anschlußkabeldurchführbereiche 47a, 47b in das Innere des Gehäuses 33 eingeführt werden, um die elektrischen Leiter (nicht gezeigt) der Anschlußkabel 49a, 49b jeweils mit einem zugeordneten Kontaktelement 17a, 17b elektrisch zu verbinden. Insbesondere im Bereich der Verbindungsstelle und/oder im Bereich innerhalb der Anschlußkabeldurchführbereiche 47a, 47b kann jeweils ein Abdichtelement 51a, 51b durch Spritzgießen ausgebildet werden, wobei eine innige Verbindung zwischen den Abdichtelementen 51a, 51b und den Anschlußkabeln 49a, 49b sowie dem Gehäuse 33 ausgebildet wird.

Die in der Figur 7 gezeigten zwei Kontaktelemente 17a, 17b können mittels einer Bypass-Diode (nicht gezeigt) miteinander elektrisch verbunden sein, wobei die Bypass-Diode mittels einer Dichtmasse 53 ummantelt sein kann. Die Ummantelung der Bypass-Diode mittels der Dichtmasse 53 kann bevorzugt durch Spritzgießen mit einem Plastomer oder einem Elastomer erfolgen, so daß die Bypass-Diode, insbesondere gemäß der Norm IP 67 oder der Norm IP 68 vor Feuchtigkeit geschützt ist.

Die Anschlußdose 31 ist feuchtigkeitsdicht mittels des Befestigungselements 37 an den Solarmodul 3 befestigt. Somit kann vorteilhafterweise auf ein Ausgießen des Inneren des Gehäuse 33 der Anschlußdose 31 verzichtet werden, wobei die Kontaktelemente 17a, 17b und die damit elektrisch kontaktierten elektrischen Leiter 13a, 13b des Solarmodulverbinders 11 des Solarmoduls 3 feuchtigkeitsdicht von der Umgebung des Solarpaneels 1 abgeschlossen sind.

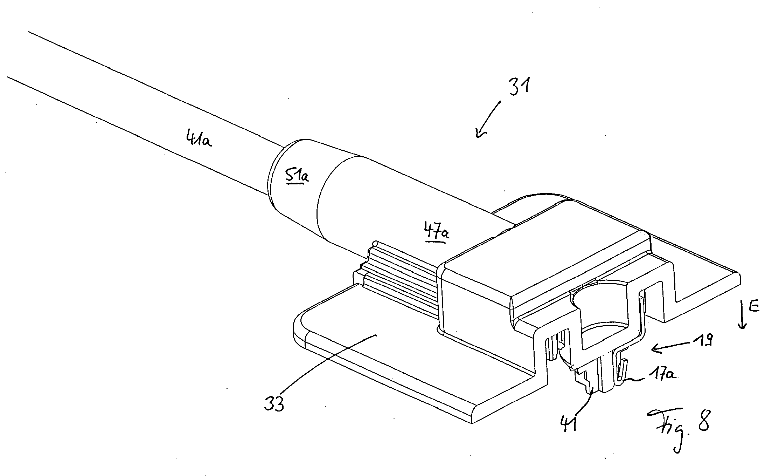

Figur 8 zeigt eine weitere Ausführungsform einer Anschlußdose 31 in einer perspektivischen Schnittansicht. Die Anschlußdose 31 umfaßt lediglich ein Kontaktelement 17a, welches elektrisch mit einem Leiter des einzigen Anschlußkabels 49a elektrisch kontaktiert ist. Das einzige Anschlußkabel 49a ist durch einen Anschlußkabeldurchführbereich 47a in das Innere des Gehäuses 33 eingeführt. Um das Innere des Gehäuses 33 der Anschlußdose 31 vor Feuchtigkeit zu schützen, kann ein Abdichtelement 51a zumindest bereichsweise innerhalb des Gehäuses 33, bevorzugt innerhalb eines von dem Anschlußkabeldurchführbereich 47a und dem Anschlußkabel 49a gebildeten Zwischenraumes angeordnet sein.

Insbesondere kann das Abdichtelement 51a mit dem Gehäuse 33 und/oder dem Anschlußkabel 49a zumindest partiell verschmolzen sein. Bevorzugt kann das Abdichtelement 51a aus einem flexibleren Material bestehen als das Material des Gehäuses 33, welches das Abdichtelement 51a umgibt. Das Abdichtelement 51a kann bereichsweise aus dem Gehäuse 33 hervorstehen, um eine Knickschutztülle für das Anschlußkabel 48a auszubilden. Vorteilhafterweise kann aufgrund der Flexibilität des Abdichtelements 51a beispielsweise das Anschlußkabel 49a bewegt werden, insbesondere gebogen werden, wobei sich das flexible Abdichtelement 51a an die Bewegung des Anschlußkabels 49a anpassen kann. Vorteilhafterweise wird dadurch ein Eindringen von Feuchtigkeit in das Gehäuse 33 der Anschlußdose 31 auch bei einer Bewegung des Anschlußkabels 49a verhindert.

Da die in Figur 8 gezeigte Anschlußdose 31 lediglich ein Kontaktelement 17a aufweist, ist die Anschlußdose 31 dazu ausgelegt, um mit einem einzigen elektrischen Leiter eines Solarmoduls elektrisch zu kontaktieren. Aus diesem Grund ist eine Bypass-Diode innerhalb der in Figur 8 gezeigten Ausführungsform der Anschlußdose 31 nicht vorgesehen.

Die Anschlußdose 31 weist einen komplementären Solarmodulverbinder 19 mit einer Führungsnut 41 als bevorzugtes komplementäres Führungselement 41 auf. Das komplementäre Führungselement 41 des komplementären Solarmodulverbinders 19 ist ausgelegt, um mit einem Führungselement eines Solarmodulverbinders eines Solarmoduls in Eingriff zu gelangen, so daß die Anschlußdose 31 beim Einführen des komplementären Solarmodulverbinders 19 in den Solarmodulverbinder des Solarmoduls bezüglich eines Azimutwinkels positioniert werden kann.

Die in Figur 8 gezeigte Anschlußdose 31 weist eine im wesentlichen flächige bzw. plane Anordnungsseite 35 auf. Es ist auch möglich, daß das Gehäuse 31 derart ausgebildet ist, daß die Anordnungsseite 35 in einer Anordnungsposition an dem Solarmodul (nicht gezeigt in Figur 8) zumindest bereichsweise eine Kante oder mehrere Kanten des Solarmoduls insbesondere eine Ecke des Solarmoduls umfängt. Insbesondere kann ein Rand des Gehäuses eine oder zwei Kanten des Solarmoduls umfangen. Hierzu kann beispielsweise das Gehäuse 31, insbesondere eine Anordnungsseite 35 des Gehäuses 31 von der Form einer planen Fläche abweichen und die Anordnungsseite 35 einen oder zwei rechte Winkel aufweisen. In anderen Worten kann die Anordnungsseite 35 zwei Flächen umfassen, die im wesentlichen senkrecht aufeinander stehen. Es ist auch möglich, daß die Anordnungsseite drei Flächen umfaßt, die jeweils senkrecht aufeinander stehen. Hierbei kann eine Fläche im wesentlichen parallel zu dem anschlußseitigen Solarmodulkörper sein und die beiden anderen Flächen im wesentlichen senkrecht dazu.

Vorteilhafterweise kann somit das Solarmodul, insbesondere eine Kante bzw. Ecke des Solarmoduls bei mechanischen Einflüssen, insbesondere bei Stößen geschützt sein. Außerdem kann die Kante bzw. Ecke des Solarmoduls vor elektrischen Einflüssen geschützt sein, da durch das Gehäuse 35 aus einem Isolator besteht und mittels dieses Isolators die Kanten bzw. die Ecke des Solarmoduls elektrisch isoliert ist. Somit wird vorzugsweise verhindert, daß ein Spannungsüberschlag an der bzw. den Kante(n) bzw. der Ecke des Solarmoduls auftritt.

### Bezugszeichenliste

- 1: Solarpaneel
- 3: Solarmodul
- 5: bestrahlungsseitiger Solarmodulkörper
- 7: anschlußseitiger Solarmodulkörper
- 9: elektrisch isolierende Schicht
- 11: Solarmodulverbinder
- 13a, 13b: elektrischer Leiter
- 15a, 15b: Leiterhalteeinrichtung
- 17a, 17b: Kontaktelement
- 19: komplementärer Solarmodulverbinder
- 21a, 21b: Leiterkontaktabschnitt
- 23: Einführbereich
- 25a, 25b: Nuten
- 27: Solarmodulverbinderöffnung
- 29: Leiterhalteeinrichtungsbefestigungselement
- 31: Anschlußdose
- 33: Gehäuse
- 35: Anordnungseite
- 37: Klebeelement, Befestigungselement
- 39: Führungselement
- 41: komplementäres Führungselement
- 43: Kontaktelementhalteeinrichtung
- 45: Bypass-Diode
- 47a ,47b: Anschlußkabeldurchführbereich
- 49a ,49b: Anschlußkabel
- 51a ,51b: Abdichtelement
- 53: Dichtmasse
- E: Einführrichtung
- K: Andruckkraft
- V: Verlagerungsrichtung

## Patentansprüche

1. Solarmodul (3), umfassend:
- einen anschlußseitigen Solarmodulkörper (7) mit zumindest einer Solarmodulverbinderöffnung (27),
- zumindest einen Solarmodulverbinder (11) mit
-- zumindest einem Einführbereich (23), in welchen zumindest ein Kontaktelement (17a, 17b) eines komplementären Solarmodulverbinders (19) entlang einer Einführrichtung (E) einführbar ist,
-- zumindest einem elektrischen Leiter (13a, 13b), welcher mit zumindest einer Solarzelle kontaktiert ist,
-- zumindest einer Leiterhalteeinrichtung (15a, 15b), welche einen zugeordneten elektrischen Leiter (13a, 13b) mechanisch fixiert, wobei sich der zugeordnete elektrische Leiter (13a, 13b) in einem Leiterkontaktabschnitt im wesentlichen parallel zur Einführrichtung (E) erstreckt,
wobei der Solarmodulverbinder (11) zumindest bereichsweise im Bereich der Solarmodulverbinderöffnung (27) in den anschlußseitigen Solarmodulkörper (7) hineinragt, **dadurch gekennzeichnet, dass** der zumindest eine elektrische Leiter (13a, 13b) als Leiterband ausgebildet ist, wobei die gegenüberliegenden Ränder des Leiterbandes jeweils in einer entlang der Einführrichtung (E) orientierten Nut der zugeordneten Leiterhalteeinrichtung (15a, 15b) gehalten sind.

2. Solarmodul (3) nach Anspruch 1, wobei die zumindest eine Leiterhalteeinrichtung (15a, 15b) als Widerlager des zugeordneten elektrischen Leiters (13a, 13b) gegenüber einer Andruckkraft (K) ausgebildet ist, welche in einer zu der Einführrichtung (E) verschiedenen Richtung auf den zugeordneten elektrischen Leiter (13a, 13b) wirkt.

3. Solarmodul (3) nach einem der vorigen Ansprüche, wobei der zumindest eine Solarmodulverbinder (11) zumindest bereichsweise zwischen einem bestrahlungsseitigen Solarmodulkörper (5) und dem anschlußseitigen Solarmodulkörper (7) angeordnet ist.

4. Solarmodul (3) nach einem der vorigen Ansprüche, wobei der Solarmodulverbinder (11) nicht entgegen der Einführrichtung (E) über den anschlußseitigen Solarmodulkörper (7) hervorsteht.

5. Solarmodul (3) nach einem der vorigen Ansprüche, wobei der Solarmodulverbinder (11) zumindest ein Führungselement (39) aufweist, welches ausgelegt ist mit einem komplementären Führungselement der Anschlußdose (31) in Eingriff zu gelangen, so daß der komplementäre Solarmodulverbinder (19) der Anschlußdose (31) entlang der Einführrichtung (E) lediglich mit einem, zwei oder vier vorbestimmten Azimutwinkeln gemessen in einer zur Einführrichtung (E) senkrecht stehenden Ebene einführbar ist.

6. Solarmodulanordnung (3, 31) mit einem Solarmodul (3) gemäß einem der vorhergehenden Ansprüche und einer Anschlußdose (31) für das Solarmodul (3), die Anschlußdose (31) umfassend:
- ein Gehäuse (33) mit einer Anordnungsseite (35), welche im wesentlichen formschlüssig an einen anschlußseitigen Solarmodulkörper (7) des Solarmoduls (3) anordenbar ist, und
- zumindest einen komplementären Solarmodulverbinder (19) mit zumindest einem Kontaktelement (17a, 17b),
wobei das zumindest eine Kontaktelement (17a, 17b) entlang einer Verlagerungsrichtung (V) rückstellfähig verformbar ist,
wobei der komplementäre Solarmodulverbinder (19) entlang einer Einführrichtung (E) über die Anordnungsseite (35) zumindest bereichsweise hervorsteht und ausgelegt ist, entlang der Einführrichtung (E) in einen Einführbereich (23) eines Solarmodulverbinders (11) des Solarmoduls (3) eingeführt zu werden.

7. Solarmodulanordnung (3, 31) nach Anspruch 6, wobei der zumindest eine komplementäre Solarmodulverbinder (19) zumindest eine Kontaktelementhalteeinrichtung (43) aufweist, wobei die zumindest eine Kontaktelementhalteeinrichtung (43) ein zugeordnetes Kontaktelement (17a, 17b) mechanisch fixiert und als Widerlager des zugeordneten Kontaktelements (17a, 17b) gegenüber einer Verlagerung entlang der Verlagerungsrichtung (V) ausgebildet ist, wobei die Verlagerungsrichtung (V) verschieden zu der Einführrichtung (E) orientiert ist.

8. Solarmodulanordnung (3, 31) nach einem der Ansprüche 6 oder 7, wobei die Anschlußdose (31) zumindest ein komplementäres Führungselement (41) aufweist, welches ausgelegt ist, mit einem Führungselement des Solarmodulverbinders (11) in Eingriff zu gelangen, so daß der komplementäre Solarmodulverbinder (19) der Anschlußdose (31) entlang einer Einführrichtung (E) lediglich mit einem, zwei oder vier vorbestimmten Azimutwinkeln - gemessen in einer zur Einführrichtung (E) senkrecht stehenden Ebene - einführbar ist.

9. Solarmodulanordnung (3, 31) nach einem der Ansprüche 6 bis 8, umfassend:
-- zumindest zwei Kontaktelemente (17a, 17b), welche mittels einer Bypass-Diode (*50) miteinander elektrisch verbunden sind.

10. Solarmodulanordnung (3, 31) nach einem der Ansprüche 6 bis 9, umfassend:
- zumindest ein elektrisches Anschlußkabel (49a ,49b), wobei ein Kabelendbereich des Anschlußkabels (49a ,49b) in das Gehäuse (33) eingeführt ist und wobei zumindest ein elektrischer Leiter des Anschlußkabels (49a ,49b) mit einem zugeordneten Kontaktelement (17a, 17b) kontaktiert, und
- zumindest ein an dem Gehäuseelement angeordnetes flexibles Abdichtelement (51a ,51b), das flexibler als das Gehäuseelement ist und das den innnerhalb des Gehäuses (33) angeordneten Kabelendbereich des Anschlußkabels (49a ,49b) umfängt und derart innig mit dem Gehäuse (33) und dem Anschlußkabel (49a ,49b) verbunden ist, daß das Innere des Gehäuses (33) im wesentlichen vollständig feuchtigkeitsdicht von der Umgebung abgeschlossen ist.

11. Solarmodulverbinderanordnung mit einer Mehrzahl von Solarmodulverbindern (11) mit
-- zumindest einem Einführbereich (23), in welchen zumindest ein Kontaktelement (17a, 17b) eines komplementären Solarmodulverbinders (19) entlang einer Einführrichtung (E) einführbar ist,
-- zumindest einem elektrischen Leiter (13a, 13b), welcher mit einer Solarzelle kontaktierbar ist, und
-- zumindest einer Leiterhalteeinrichtung (15a, 15b), welche einen zugeordneten elektrischen Leiter (13a, 13b) mechanisch fixiert, wobei sich der zugeordnete elektrische Leiter (13a, 13b) in einem Leiterkontaktabschnitt im wesentlichen parallel zur Einführrichtung (E) erstreckt,
wobei ein Solarmodulverbinder (11) mittels eines Verbindungselementes mit einem benachbarten Solarmodulverbinder mechanisch verbunden ist, **dadurch gekennzeichnet, dass** der zumindest eine elektrische Leiter (13a, 13b) als Leiterband ausgebildet ist, wobei die gegenüberliegenden Ränder des Leiterbandes jeweils in einer entlang der Einführrichtung (E) orientierten Nut der zugeordneten Leiterhalteeinrichtung (15a, 15b) gehalten sind.

12. Verfahren zum Herstellen eines Solarmoduls (3) umfassend die Schritte:
- Bereitstellen eines bestrahlungsseitigen Solarmodulkörpers (5) mit zumindest einer anschlußseitig angeordneten Solarzelle,
- Anordnen zumindest eines Solarmodulverbinders (11) an der Anschlußseite dem bestrahlungsseitigen Solarmodulkörper (5), wobei der zumindest eine Solarmodulverbinder (11) weiter umfaßt:
-- zumindest einen Einführbereich (23), in welchen ein komplementärer Solarmodulverbinder entlang einer Einführrichtung (E) einführbar ist,
-- zumindest einen elektrischen Leiter (13a, 13b),
-- zumindest eine Leiterhalteeinrichtung (15a, 15b), welche einen zugeordneten elektrischen Leiter (13a, 13b) mechanisch fixiert, wobei sich der zugeordnete elektrische Leiter (13a, 13b) in einem Leiterkontaktabschnitt im wesentlichen parallel zur Einführrichtung (E) erstreckt, wobei der zumindest eine elektrische Leiter (13a, 13b) als Leiterband ausgebildet ist und wobei die gegenüberliegenden Ränder des Leiterbandes jeweils in einer entlang der Einführrichtung (E) orientierten Nut der zugeordneten Leiterhalteeinrichtung (15a, 15b) gehalten sind,
- Kontaktieren zumindest eines des zumindest einen elektrischen Leiters (13a, 13b) mit einer der zumindest einen Solarzelle,
- Anordnen an einem anschlußseitigen Solarmodulkörper (7) mit zumindest einer Solarmodulverbinderöffnung (27), wobei der Solarmodulverbinder (11) zumindest bereichsweise im Bereich der Solarmodulverbinderöffnung (27) in den anschlußseitigen Solarmodulkörper (7) hinein ragt.

13. Verwendung einer Solarmodulanordnung (3, 31) gemäß einem der Ansprüche 6 bis 10 zur Ausbildung eines Solarpaneels (1), wobei die Anschlußdose (31) derart an das Solarmodul (3) angeordnet wird, daß der komplementäre Solarmodulverbinder (19) der Anschlußdose (31) entlang der Einführrichtung (E) zumindest bereichsweise in den Solarmodulverbinder (11) des Solarmodul (3) eingeführt wird, wobei jedes Kontaktelement (17a, 17b) einen zugeordneten elektrischen Leiter (13a, 13b) kontaktiert.

14. Verwendung nach Anspruch 13, wobei eines des zumindest einen Kontaktelements (17a, 17b) der Anschlußdose (31) entlang der Verlagerungsrichtung (V) eine vorbestimmte Andruckkraft (K) auf einen zugeordneten elektrischen Leiter (13a, 13b) des Solarmodulverbinders (3) anlegt, wobei die Verlagerungsrichtung (V) im wesentlichen senkrecht zu der Einführrichtung (E) orientiert ist.

## Claims

1. A solar module (3), comprising:
- a connection-side solar module body (7) with at least one solar module connector opening (27),
- at least one solar module connector (11) with
-- at least one insertion region (23) in which at least one contact element (17a, 17b) of a complementary solar module connector (19) can be inserted along an insertion direction (E),
-- at least one electrical conductor (13a, 13b) that can be contacted with at least one solar cell,
-- at least one conductor holding device (15a, 15b) that mechanically fixes an associated electrical conductor (13a, 13b), wherein the associated electrical conductor (13a, 13b) extends in a conductor contact section essentially parallel to the insertion direction (E),
wherein the solar module connector (11) extends at least sectionally into the connection-side solar module body (7) in the region of the solar module connector opening (27), **characterized in that** the at least one electrical conductor (13a, 13b) is designed as a conductor track, wherein the opposing edges of the conductor track are held in a groove of the associated conductor holding device (15a, 15b) oriented along the insertion direction (E).

2. The solar module (3) according to claim 1, wherein the at least one conductor holding device (15a, 15b) is designed as an abutment of the associated electrical conductor (13a, 13b) against a pressure (K) which, in a direction different than the insertion direction (E), acts on the associated electrical conductor (13a, 13b).

3. The solar module (3) according to one of the preceding claims, wherein the at least one solar module connector (11) is at least sectionally arranged between an irradiation-side solar module body (5) and the connection-side solar module body (7).

4. The solar module (3) according to one of the preceding claims, wherein the solar module connector (11) does not project beyond the connection-side solar module body (7) opposite the insertion direction.

5. The solar module (3) according to one of the preceding claims, wherein the solar module connector (11) has at least one guide element (39) that is designed to engage with a complementary guide element of the connection socket (31) so that the complementary solar module connector (19) of the connection socket (31) along the insertion direction (E) can only be inserted with one, two, or four predetermined azimuth angles measured in a plane perpendicular to the insertion direction (E).

6. The solar module arrangement (3, 31) with a solar module (3) according to one of the preceding claims and a connection socket (31) for the solar module (3), the connection socket (31) comprising:
- a housing (33) with an arrangement side (35) that can be arranged substantially in a form fit on a connection-side solar module body (7) of the solar module (3), and
- at least one complementary solar module connector (19) with at least one contact element (17a, 17b),
wherein the at least one contact element (17a, 17b) is restorably deformable along a displacement direction (V),
wherein the complementary solar module connector (19) projects at least sectionally along an insertion direction (E) beyond the arrangement side (35), and is designed to be inserted along the insertion direction (E) into an insertion region (23) of a solar module connector (11) of the solar module (3).

7. The solar module arrangement (3, 31) according to claim 6, wherein the at least one complimentary solar module connector (19) has at least one contact element holding device (43), wherein the at least one contact element holding device (43) mechanically fixes an associated contact element (17a, 17b) and is designed as an abutment for the associated contact element (17a, 17b) against a displacement along the displacement direction (V), wherein the displacement direction (V) is oriented different than the insertion direction (E).

8. The solar module (3, 31) according to one of claims 6 or 7, wherein the connecting socket (31) has at least one complementary guide element (41) that is designed to engage with a guide element of the solar module connector (11) so that the complementary solar module connector (19) of the connection socket (31) along an insertion direction (E) can only be inserted with one, two, or four predetermined azimuth angles measured in a plane perpendicular to the insertion direction (E).

9. The solar module arrangement (3, 31) according to one of claims 6 to 8, comprising:
- at least two contact elements (17a, 17b) that are electrically connected to each other by means of a bypass diode (*50).

10. The solar module arrangement (3, 31) according to one of claims 6 to 9, comprising:
- at least one electrical connecting cable (49a, 49b), wherein a cable end region of the connecting cable (49a, 49b) is inserted into the housing (33), and wherein at least one electrical conductor of the connecting cable (49a, 49b) is contacted with an associated contact element (17a, 17b), and
- at least one flexible sealing element (51a, 51b) which is more flexible than the housing element and surrounds the cable end region of the connecting cable (49a, 49b) arranged within the housing (33), and is so tightly connected to the housing (33) and the connecting cable (49a, 49b) that the interior of the housing (33) is sealed substantially moisture-tight from the surroundings.

11. A solar module connector arrangement with a plurality of solar module connectors (11) with:
-- at least one insertion region (23) in which at least one contact element (17a, 17b) of a complementary solar module connector (19) can be inserted along an insertion direction (E),
-- at least one electrical conductor (13a, 13b) that can be contacted with at least one solar cell, and
-- at least one conductor holding device (15a, 15b) that mechanically fixes an associated electrical conductor (13a, 13b), wherein the associated electrical conductor (13a, 13b) extends in a conductor contact section essentially parallel to the insertion direction (E),
wherein a solar module connector (11) is mechanically connected to an adjacent solar module connector by means of a connecting element, **characterized in that** the at least one electrical conductor (13a, 13b) is designed as a conductor strip, wherein the opposing edges of the conductor strip are held in a groove of the associated conductor holding device (15a, 15b) oriented along the insertion direction (E).

12. A method to produce a solar module (3) comprising the steps:
- provide a radiation-side solar module body (5) with at least one solar cell arranged on a connection side,
- arrange at least one solar module connector (11) on the connection side of the irradiation-side solar module body (5), wherein the at least one solar module connector (11) moreover comprises:
-- at least one insertion region (23) in which a complementary solar module connector can be inserted along an insertion direction (E),
-- at least one electrical conductor (13a, 13b),
-- at least one conductor holding device (15a, 15b) that mechanically fixes an associated electrical conductor (13a, 13b), wherein the associated electrical conductor (13a, 13b) extends in a conductor contact section substantially parallel to the insertion direction (E), wherein the at least one electrical conductor (13a, 13b) is designed as a conductor strip, and wherein the opposing edges of the conductor strip are held in a groove in the associated conductor holding device (15a, 15b) oriented along the insertion direction (E),
- contact at least one of the at least one electrical conductor (13a, 13b) with one of the at least one solar cell,
- arrangement on a connection-side solar module body (7) with at least one solar module connector opening (27), wherein the solar module connector (11) extends at least sectionally in the region of the solar module connector opening (27) into the connection-side solar module body (7).

13. A use of a solar module arrangement (3, 31) according to one of claims 6 to 10 to form a solar panel (1), wherein the connection socket (31) is arranged on the solar module (3) such that the complementary solar module connector (19) of the connection socket (31) is inserted at least sectionally along the insertion direction (E) into the solar module connector (11) of the solar module (3), wherein each contact element (17a, 17b) contacts an associated electrical conductor (13a, 13b).

14. The use according to claim 13, wherein one of the at least one contact elements (17a, 17b) of the connecting socket (31) applies a predetermined pressure (K) along the displacement direction (V) on an associated electrical conductor (13a, 13b) of the solar module connector (3), wherein the displacement direction (V) is oriented substantially perpendicular to the insertion direction (E).

## Revendications

1. Module solaire (3), comportant :
- un corps de module solaire (7) côté raccordement avec au moins une ouverture de connecteur de module solaire (27),
- au moins un connecteur de module solaire (11) avec
- au moins une partie d'insertion (23), dans laquelle au moins un élément de contact (17a, 17b) d'un connecteur de module solaire (19) complémentaire est susceptible d'être inséré le long d'une direction d'insertion (E),
- au moins un conducteur électrique (13a, 13b), lequel est mis en contact avec au moins une cellule solaire,
- au moins un dispositif de retenue de conducteur (15a, 15b), lequel fixe mécaniquement un conducteur électrique associé (13a, 13b), où le conducteur électrique associé (13a, 13b) s'étend, dans une partie de mise en contact de conducteur, essentiellement parallèlement par rapport à la direction d'insertion (E),
où le connecteur de module solaire (11) pénètre, au moins par endroits, dans la partie de l'ouverture de connecteur de module solaire (27), dans le corps de module solaire (7) côté raccordement, **caractérisé en ce que** ledit au moins un conducteur électrique (13a, 13b) est conçu en tant que bande conductrice, où les bords opposés de la bande conductrice sont retenus respectivement dans une rainure du dispositif de retenue de conducteur associé (15a, 15b) orientée le long de la direction d'insertion (E).

2. Module solaire (3) selon la revendication 1, où ledit au moins un dispositif de retenue de conducteur (15a, 15b) est conçu en tant que butée du conducteur électrique associé (13a, 13b) par rapport à une force de pression (K), laquelle agit, dans une direction différente par rapport à la direction d'insertion (E), sur le conducteur électrique associé (13a, 13b).

3. Module solaire (3) selon l'une quelconque des revendications précédentes, où le au moins un connecteur de module solaire (11) est agencé, au moins par endroits, entre un corps de module solaire (5) côté rayonnement et le corps de module solaire (7) côté raccordement.

4. Module solaire (3) selon l'une quelconque des revendications précédentes, où le connecteur de module solaire (11) ne dépasse pas, contre la direction d'insertion (E), au-delà du corps de module solaire (7) côté raccordement.

5. Module solaire (3) selon l'une quelconque des revendications précédentes, où le connecteur de module solaire (11) présente au moins un élément de guidage (39), lequel est conçu pour venir en prise avec un élément de guidage complémentaire du boîtier de raccordement (31), de sorte que le connecteur de module solaire complémentaire (19) du boîtier de raccordement (31) est susceptible d'être inséré, le long de la direction d'insertion (E), notamment avec un, deux, ou quatre angles azimutaux prédéterminés, mesurés dans un plan étant perpendiculaire par rapport à la direction d'insertion (E).

6. Agencement de module solaire (3, 31) avec un module solaire (3) selon l'une quelconque des revendications précédentes et un boîtier de raccordement (31) pour le module solaire (3), le boîtier de raccordement (31) comportant :
- un logement (33) avec un côté d'agencement (35), lequel est susceptible d'être agencé, essentiellement par liaison de forme, sur un corps de module solaire (7) côté raccordement du module solaire (3), et
- au moins un connecteur de module solaire complémentaire (19) avec au moins un élément de contact (17a, 17b),
où ledit au moins un élément de contact (17a, 17b) est déformable de manière résiliente le long d'une direction de déplacement (V),
où le connecteur de module solaire complémentaire (19) est agencé et dépasse, au moins par endroits, le long d'une direction d'insertion (E), au-delà du côté d'agencement (35) et est conçu de sorte à pouvoir être inséré, le long d'une direction d'insertion (E), dans un partie d'insertion (23) d'un connecteur de module solaire (11) du module solaire (3).

7. Agencement de module solaire (3, 31) selon la revendication 6, où ledit au moins un connecteur de module solaire complémentaire (19) présente au moins un dispositif de retenue d'élément de contact (43), où ledit au moins un dispositif de retenue d'élément de contact (43) fixe mécaniquement un élément de contact associé (17a, 17b) est en conçu en tant que butée de l'élément de contact associé (17a, 17b) par rapport à un déplacement le long de la direction de déplacement (V), où la direction de déplacement (V) est orientée différemment par rapport à la direction d'insertion (E).

8. Agencement de module solaire (3, 31) selon une des revendications 6 ou 7, où le boîtier de raccordement (31) présente au moins un élément de guidage complémentaire (41), lequel est conçu pour venir en prise avec un élément de guidage du connecteur de module solaire (11), de sorte que le connecteur de module solaire complémentaire (19) du boîtier de raccordement (31) est susceptible d'être inséré, le long de la direction d'insertion (E), notamment avec un, deux, ou quatre angles azimutaux prédéterminés, mesurés dans un plan étant perpendiculaire par rapport à la direction d'insertion (E).

9. Agencement de module solaire (3, 31) selon une des revendications de 6 à 8, comportant
- au moins deux éléments de contact (17a, 17b), lesquels sont reliés électriquement l'un à l'autre à l'aide d'une diode bypass (*50).

10. Agencement de module solaire (3, 31) selon une des revendications de 6 à 9, comportant
- au moins un câble de raccordement électrique (49a ,49b), où une partie d'extrémité de câble du câble de raccordement (49a, 49b) est inséré dans le logement (33) et où au moins un conducteur électrique du câble de raccordement (49a ,49b) est mis en contact avec un élément de contact associé (17a, 17b), et
- au moins un élément d'étanchéité flexible (51a, 51b) agencé sur l'élément de logement qui est plus souple que l'élément de logement et qui entoure la partie d'extrémité de câble du câble de raccordement (49a ,49b) agencée à l'intérieur du logement (33) et qui est relié intimement au logement (33) et au câble de raccordement (49a ,49b) de telle sorte que l'intérieur du logement (33) est isolé de l'espace environnant essentiellement de manière entièrement étanche à l'humidité.

11. Agencement de connecteurs de module solaire avec une multitude de connecteurs de module solaire (11) avec
- au moins une partie d'insertion (23), dans laquelle au moins un élément de contact (17a, 17b) d'un connecteur de module solaire complémentaire (19) est susceptible d'être inséré le long d'une direction d'insertion (E),
- au moins un conducteur électrique (13a, 13b), lequel est susceptible d'être mis en contact avec une cellule solaire, et
- au moins un dispositif de retenue de conducteur (15a, 15b), lequel fixe mécaniquement un conducteur électrique associé (13a, 13b), où le conducteur électrique associé (13a, 13b) s'étend, dans une partie de contact de conducteur, essentiellement parallèlement par rapport à la direction d'insertion (E),
où un connecteur de module solaire (11) est relié mécaniquement, à l'aide d'un élément de liaison, au connecteur de module solaire adjacent, **caractérisé en ce que** ledit au moins un conducteur électrique (13a, 13b) est conçu en tant que bande conductrice, où les bords opposés de la bande conductrice sont retenus respectivement dans une rainure du dispositif de retenue de conducteur associé (15a, 15b) orientée le long de la direction d'insertion (E).

12. Procédé de production d'un module solaire (3) comportant les étapes :
- mise à disposition d'un corps de module solaire (5) côté rayonnement avec au moins une cellule solaire agencée côté raccordement,
- agencement d'au moins un connecteur de module solaire (11), du côté raccordement, sur le corps de module solaire côté rayonnement (5), où ledit au moins un connecteur de module solaire (11) comporte en outre :
- au moins une partie d'insertion (23), dans laquelle un connecteur de module solaire complémentaire est susceptible d'être inséré le long d'une direction d'insertion (E),
- au moins un conducteur électrique (13a, 13b),
- au moins un dispositif de retenue de conducteur (15a, 15b), lequel fixe mécaniquement un conducteur électrique associé (13a, 13b), où le conducteur électrique associé (13a, 13b) s'étend, dans une partie de contact de conducteur, essentiellement parallèlement par rapport à la direction d'insertion (E), où ledit au moins un conducteur électrique (13a, 13b) est conçu en tant que bande conductrice, où les bords opposés de la bande conductrice sont retenus respectivement dans une rainure du dispositif de retenue de conducteur associé (15a, 15b) orientée le long de la direction d'insertion (E).
- entrée en contact d'au moins un dudit au moins un conducteur électrique (13a, 13b) avec une de ladite au moins une cellule solaire,
- agencement sur un corps de module solaire (7) côté raccordement avec au moins une ouverture de connecteur de module solaire (27), où le connecteur de module solaire (11) pénètre, au moins par endroits, dans la partie de l'ouverture de connecteur de module solaire (27), dans le corps de module solaire (7) côté raccordement.

13. Utilisation d'un agencement de module solaire (3, 31) selon une des revendications de 6 à 10 pour la formation d'un panneau solaire (1), où le boîtier de raccordement (31) est agencé de telle sorte sur le module solaire (3) que le connecteur de module solaire complémentaire (19) du boîtier de raccordement (31) est inséré, le long de la direction d'insertion (E), au moins par endroits, dans le connecteur de module solaire (11) du module solaire (3), où chaque élément de contact (17a, 17b) est mis en contact avec un conducteur électrique associé (13a, 13b).

14. Utilisation selon la revendication 13, où un dudit au moins un élément de contact (17a, 17b) du boîtier de raccordement (31) applique, le long d'une direction de déplacement (V), une force de pression prédéterminée (K) sur un conducteur électrique associé (13a, 13b) du connecteur de module solaire (3), où la direction de déplacement (V) est orientée essentiellement parallèlement par rapport à la direction d'insertion (E).
